# EUROPÄISCHE PATENTSCHRIFT

(11) **EP 3 321 973 B1**
(45) Veröffentlichungstag und Bekanntmachung des Hinweises auf die Patenterteilung: **06.01.2021**
(21) Anmeldenummer: 16197972.9
(22) Anmeldetag: 09.11.2016
(51) Int. Cl.: H01L 31/0216, H01L 31/068

(54) **KRISTALLINE SOLARZELLE MIT EINER TRANSPARENTEN, LEITFÄHIGEN SCHICHT ZWISCHEN DEN VORDERSEITENKONTAKTEN UND VERFAHREN ZUR HERSTELLUNG EINER SOLCHEN SOLARZELLE**
CRYSTALLINE SOLAR CELL HAVING A TRANSPARENT, CONDUCTIVE LAYER BETWEEN THE FRONT CONTACTS AND METHOD FOR MANUFACTURING SUCH A SOLAR CELL
PHOTOPILE CRISTALLINE COMPRENANT UNE COUCHE CONDUCTRICE TRANSPARENTE ENTRE LES CONTACTS AVANT ET PROCÉDÉ DE FABRICATION D'UNE TELLE PHOTOPILE

(43) Veröffentlichungstag der Anmeldung: 16.05.2018
(73) Patentinhaber: Meyer Burger (Germany) GmbH, 09337 Hohenstein-Ernstthal (DE)
(72) Erfinder: Sperlich, Hans-Peter, 01309 Dresden (DE); Erfurt, Gunter, 09599 Freiberg (DE); Grosse, Thomas, 08371 Glauchau (DE); Marcel, König, Chemnitz (DE)
(74) Vertreter: Kailuweit & Uhlemann Patentanwälte Partnerschaft mbB

(56) Entgegenhaltungen:
- EP-A1- 0 548 863
- DE-A1- 3 831 857
- DE-A1-102011 002 280
- DE-A1-102013 219 561

## Beschreibung

Die Erfindung betrifft eine kristalline Solarzelle aus einem Halbleitermaterial, die auf der Vorderseite eine transparente, leitfähige Schicht zwischen den elektrischen Kontakten aufweist, sowie ein Verfahren zur Herstellung einer solchen Solarzelle.

Herkömmliche Si-Solarzellen bestehen aus zwei entgegengesetzt dotierten Bereichen eines einkristallinen oder auch multikristallinen Halbleitermaterials. Dabei wird ein direkter pn-Übergang zwischen den beiden Bereichen durch das Einbringen von Dotanden in das Halbleitermaterial oder durch das Aufbringen einer Schicht aus dem gleichen Halbleitermaterial auf eine erste Schicht des Halbleitermaterials, wobei die zweite Schicht eine der Dotierung der ersten Schicht entgegengesetzte Dotierung aufweist, erzeugt. Eine solche Solarzelle wird auch Homo-Zelle im Gegensatz zu einer Hetero-Zelle, die aus unterschiedlichen Halbleitermaterialien besteht oder zwischen der n- und der p-Schicht noch eine intrinsische Schicht aufweist (pin-Übergang), genannt. Dabei wird bereits eine andere Struktur eines Halbleiters, bspw. amorph statt kristallin, als unterschiedliches Halbleitermaterial verstanden. Die entgegengesetzt dotierten Bereiche der Solarzelle werden elektrisch kontaktiert, wobei in vielen Solarzellen die Kontakte auf einander gegenüberliegenden Oberflächen des Halbleitermaterials, also auf der Vorderseite und der Rückseite der Solarzelle, angeordnet sind. Zur Verbesserung der Performance der Solarzelle werden die Oberflächen des Halbleitermaterials oftmals mit dielektrischen Schichten passiviert, wobei diese Passivierschichten auf der Vorderseite der Solarzelle, d.h. auf der der Lichtquelle zugewandten Seite, transparent sind und oft auch eine antireflektierende Wirkung haben oder durch eine Antireflektionsschicht ergänzt werden.

Die elektrischen Kontakte werden zumindest auf der Vorderseite der Solarzelle nur lokal ausgebildet, um den Lichteinfall in das Halbleitermaterial durch das optisch intransparente elektrisch leitende Material, meist ein Metall, nur wenig zu behindern. Dazu wird das elektrisch leitende Material auf der Passivierungsschicht abgeschieden und der elektrische Kontakt anschließend durch Diffusion des elektrisch leitfähigen Materials durch die Passivierungsschicht bis zum Halbleitermaterial (Durchfeuern, Firing) erzeugt. Dabei entsteht ein direkter Kontakt zwischen dem elektrisch leitenden Material und dem Halbleitermaterial. Das Durchfeuern wird bei Temperaturen im Bereich von über 560°C bis 600°C ausgeführt.

Die Rückseite der Solarzelle wird bei einigen Typen von Solarzellen (z.B. PERC-Zelle, Passivated Emitter Rear Contact) nur lokal kontaktiert, während die restlichen lateralen Abschnitte der Rückseite mit einer dielektrischen passivierenden Schicht versehen bleiben. Bei einigen Solarzellen ist die gesamte Rückseite mit einer passivierenden Schicht versehen und der elektrische Kontakt durch das Tunneln von Ladungsträgern durch diese Schicht realisiert (TOPCon-Zelle, Tunnel Oxide Passivated Contact). Diese Maßnahmen dienen der Reduzierung der Ladungsträgerrekombination an der Kontaktfläche zwischen elektrisch leitendem Material (Metall) und Halbleitermaterial.

Um die Anzahl und Wirkung von Grenzflächenzuständen an der Oberfläche des Halbleitermaterials zu minimieren, wird der Emitter der Solarzelle, d.h. einer der beiden Halbleiterbereiche, weniger stark dotiert, wodurch jedoch die elektrische Leitfähigkeit dieses Bereiches sinkt. Bei einem hoch dotierten Emitter liegt der Flächenwiderstand im Bereich von 50 bis 100 Ω (Ω/□), während ein schwach dotierter Emitter einen Flächenwiderstand im Bereich von 100 bis 200 Ω (Ω/□) aufweist. Ein Ansatz zur Lösung dieses Problems ist die stärkere Dotierung nur eines kleinen lateralen Abschnitts des Emitters direkt unterhalb des elektrischen Kontaktes, so dass dieser Abschnitt einen Flächenwiderstand von ca. 60 Ω (Ω/□) aufweist.

Ein anderer Ansatz, der in der US 2010/0012179 A1 beschrieben ist, ist die ganzflächige Abscheidung eines elektrisch leitenden, optisch transparenten Materials, z.B. eines transparenten leitfähigen Oxids (TCO, transparent conducting oxide), auf dem Halbleitermaterial, gefolgt von einer Antireflektionsschicht, auf die ein Metall abgeschieden und anschließend durch die Antireflektionsschicht hindurchgefeuert wird. Die erhaltene Struktur ist dadurch gekennzeichnet, dass das Halbleitermaterial auf der Vorderseite der Solarzelle ganzflächig durch das elektrisch leitende, optisch transparente Material kontaktiert wird, welches wiederum elektrisch leitend mit den Metallkontakten verbunden ist.

Jedoch führt das Durchfeuern zu einer starken thermischen Belastung des Schichtstapels, wodurch es sowohl zu unerwünschten Effekten im Halbleitermaterial als auch zu einer Degradation des elektrisch leitenden, optisch transparenten Materials kommen kann, wodurch letztlich die Verbesserung der elektrische Kontaktierung des Halbleitermaterials sowie der Performance der Solarzelle wieder eingeschränkt wird. Darüber hinaus ist der Schritt zum Durchfeuern mit hohen Kosten und einem hohen Zeitaufwand verbunden. Des Weiteren wurden Probleme bezüglich der Haftung des Metalls auf dem elektrisch leitenden, optisch transparenten Material beobachtet, die zu einer Degradation der Langzeitstabilität und letztlich einem Ausfall der Solarzelle führen.

Die DE 38 31 857 A1 beschreibt eine Inversionsschicht-Solarzelle, bei der eine Raumladungszone im Halbleitermaterial durch die Erzeugung einer Verarmungszone an der Halbleiteroberfläche erreicht wird. Diese Verarmungszone ist durch ein auf der Halbleiteroberfläche aufgebrachtes Dielektrikum mit einer hohen positiven, ortsfesten Ladung bedingt. Das Dielektrikum kann aus Si, SiN, Mischformen oder anderen Dielektrika sowie Schichtstapeln daraus bestehen. Es ist eine hohe Ladungsdichte im Dielektrikum gewünscht, um eine hohe Inversionsladungsträgerdichte nahe der Halbleiteroberfläche zu erreichen. Das Dielektrikum erstreckt sich dabei zwischen den Metallkontakten auf der Vorderseite entlang der gesamten Halbleiteroberfläche, wobei es die Metallkontakte berührt, und ist optisch transparent. Zwischen dem Dielektrikum und der Halbleiteroberfläche ist ein Tunneloxid angeordnet.

Daher ist es Aufgabe der vorliegenden Erfindung, eine Solarzelle und ein Verfahren zur Herstellung einer solchen Solarzelle bereitzustellen, die die Nachteile des Standes der Technik verringern und insbesondere eine verbesserte Performance der Solarzelle und eine Reduzierung der Herstellungskosten ermöglicht.

Diese Aufgabe wird gelöst durch eine kristalline Solarzelle gemäß Anspruch 1 und ein Verfahren gemäß Anspruch 11. Vorteilhafte Weiterbildungen und Ausführungsformen finden sich in den Unteransprüchen.

Eine erfindungsgemäße kristalline Solarzelle weist einen ersten Bereich eines Halbleitermaterials mit einer ersten Dotierung, einen zweiten Bereich des Halbleitermaterials mit einer zweiten Dotierung, mindestens einen Vorderseitenkontakt aus einem ersten optisch intransparenten, elektrisch leitfähigen Material, der den ersten Bereich des Halbleitermaterials direkt oder indirekt in ersten lateralen Bereichen der Vorderseite der Solarzelle elektrisch leitend kontaktiert, und mindestens einen Rückseitenkontakt aus einem zweiten optisch intransparenten, elektrisch leitfähigen Material, der den zweiten Bereich des Halbleitermaterials direkt oder indirekt in ersten lateralen Bereichen der Rückseite der Solarzelle elektrisch leitend kontaktiert, auf. Mindestens über die Vorderseite der Solarzelle gelangt Licht bzw. eine elektromagnetische Strahlung in das Halbleitermaterial der Solarzelle. Die Vorder- und die Rückseite der Solarzelle sind einander gegenüberliegende Seiten oder Oberflächen der Solarzelle. Die erste Dotierung und die zweite Dotierung sind so gewählt, dass ein pn-Übergang zwischen dem ersten und dem zweiten Bereich vorliegt.

Erfindungsgemäß ist auf der Vorderseite der Solarzelle ausschließlich in zweiten lateralen Bereichen eine Schicht aus einem ersten optisch transparenten, elektrisch leitfähigen Material über dem ersten Bereich des Halbleitermaterials angeordnet und mit dem mindestens einen Vorderseitenkontakt elektrisch leitend verbunden. Dabei ist zwischen der Schicht aus dem ersten optisch transparenten, elektrisch leitfähigen Material und dem ersten Bereich des Halbleitermaterials eine erste Oberflächenpassivierungsschicht angeordnet, durch die Ladungsträger hindurchtreten können. Damit steht die Schicht aus dem ersten optisch transparenten, elektrisch leitfähigen Material in indirektem, elektrisch leitendem Kontakt mit dem ersten Bereich des Halbleitermaterials. Die zweiten lateralen Bereiche der Vorderseite der Solarzelle sind von den ersten lateralen Bereichen der Vorderseite der Solarzelle verschieden. Die Oberflächenpassivierungsschicht, die vorzugsweise sehr dünn ausgebildet ist, verbessert die chemische Passivierung der Oberfläche des Halbleitermaterials und/oder reduziert die Anzahl und/oder Wirkung der Grenzflächenzustände an der Oberfläche des Halbleitermaterials.

Im Sinne der Anmeldung wird unter einem direkten elektrisch leitenden Kontakt ein direkter physischer, ohmscher Kontakt zwischen zwei elektrisch leitenden Materialien oder Bereichen verstanden. Demgegenüber wird unter einem indirekten elektrisch leitenden Kontakt ein Kontakt verstanden, bei dem sich zwischen den beiden genannten elektrisch leitenden Materialien oder Bereichen ein weiteres Material oder ein weiterer Bereich befindet, das bzw. der entweder ebenfalls elektrisch leitend ist oder das bzw. der zwar dielektrisch, jedoch derart ausgestaltet ist, dass Ladungsträger durch dieses dielektrische Material bzw. Bereich hindurchtreten können. Insbesondere kann das dielektrische Material oder der dielektrische Bereich so dünn ausgebildet sein, dass Ladungsträger durch ihn hindurchtunneln können.

Unter lateralen Bereichen einer Vorder- oder einer Rückseite der Solarzelle werden Bereiche der Solarzelle verstanden, die eine definierte Ausdehnung in einer Ebene der Vorder- bzw. der Rückseite der Solarzelle haben. In Dickenrichtung der Solarzelle, d.h. in einer Richtung, die Vorder- und Rückseite der Solarzelle senkrecht verbindet, erstrecken sich diese Bereiche jeweils von der Vorder- bzw. der Rückseite der Solarzelle bis zur jeweiligen Oberfläche des Halbleitermaterials. Die lateralen Bereiche können beliebige Formen in der Draufsicht auf die Vorder- bzw. die Rückseite haben, bspw. rund, eckig, linienförmig etc.

Unter einem optisch transparenten Material wird ein Material verstanden, das Licht bzw. eine elektromagnetische Strahlung mit einer Wellenlänge, die von dem Halbleitermaterial der Solarzelle absorbiert wird, hindurchtreten lässt und kaum absorbiert oder reflektiert. Unter einem optisch intransparenten Material wird demgegenüber ein Material verstanden, das Licht bzw. eine elektromagnetische Strahlung mit einer Wellenlänge, die von dem Halbleitermaterial der Solarzelle absorbiert wird, absorbiert oder reflektiert und kaum hindurchtreten lässt.

Die Schicht aus dem ersten optisch transparenten, elektrisch leitfähigen Material verbessert die Performance der Solarzelle, da sie Ladungsträger aus dem ersten Bereich des Halbleitermaterials in den zweiten lateralen Bereichen der Vorderseite der Solarzelle einsammelt und durch die höhere elektrische Leitfähigkeit in lateraler Richtung gegenüber dem ersten Bereich des Halbleitermaterials besser zu dem mindestens einen Vorderseitenkontakt abführt, als dies im Stand der Technik möglich ist.

Vorzugsweise kommt als Halbleitermaterial Silizium, insbesondere einkristallines Silizium, zum Einsatz.

Vorzugsweise ist die erste Oberflächenpassivierungsschicht auch zwischen dem mindestens einem Vorderseitenkontakt und dem ersten Bereich des Halbleitermaterials angeordnet.

In einer bevorzugten Ausführungsform ist in zweiten lateralen Bereichen der Rückseite der Solarzelle eine Schicht aus einem elektrisch isolierenden Material über dem zweiten Bereich des Halbleitermaterials angeordnet, so dass der zweite Bereich des Halbleitermaterials in den zweiten lateralen Bereichen elektrisch isoliert ist, insbesondere gegenüber einer elektrischen Verbindungsleitung, die den mindestens einen Rückseitenkontakt mit einem elektrischen Anschluss außerhalb der Solarzelle verbindet. Die zweiten lateralen Bereiche der Rückseite der Solarzelle sind von den ersten lateralen Bereichen der Rückseite der Solarzelle verschieden.

In einer anderen bevorzugten Ausführungsform ist in zweiten lateralen Bereichen der Rückseite der Solarzelle eine Schicht aus einem zweiten optisch transparenten, elektrisch leitfähigen Material über dem ersten Bereich des Halbleitermaterials angeordnet und mit dem mindestens einen Rückseitenkontakt elektrisch leitend verbunden. Dabei steht die Schicht aus dem zweiten optisch transparenten, elektrisch leitfähigen Material in direktem oder indirektem, elektrisch leitendem Kontakt mit dem zweiten Bereich des Halbleitermaterials. Die zweiten lateralen Bereiche der Rückseite der Solarzelle sind von den ersten lateralen Bereichen der Rückseite der Solarzelle verschieden.

In der zuletzt beschriebenen Ausführungsform ist das zweite optisch transparente, elektrisch leitfähige Material vorzugsweise auch zwischen dem zweiten Bereich des Halbleitermaterials und dem Rückseitenkontakt, also auch in den ersten lateralen Bereichen der Rückseite der Solarzelle, angeordnet.

Analog wie mit Bezug auf die Vorderseite der Solarzelle beschrieben, ist vorzugsweise zwischen der Schicht aus dem zweiten optisch transparenten, elektrisch leitfähigen Material und dem zweiten Bereich des Halbleitermaterials und/oder zwischen dem Rückseitenkontakt und dem zweiten Bereich des Halbleitermaterials eine zweite Oberflächenpassivierungsschicht angeordnet, durch die Ladungsträger hindurchtreten können. Auch hier ergeben sich die oben beschriebenen Vorteile.

Die Ausführungsformen, bei denen auch auf der Rückseite der Solarzelle ein optisch transparentes, elektrisch leitfähiges Material angeordnet ist, sind besonders vorteilhaft für bifaciale (bifaziale) Solarzellen, bei denen Licht sowohl von der Vorder- als auch der Rückseite in das Halbleitermaterial einstrahlen kann.

Vorzugsweise sind das erste und gegebenenfalls das zweite optisch transparente, elektrisch leitfähige Material aus der Gruppe bestehend aus Indium-Zinn-oxid, Fluor-Zinn-Oxid, Aluminium- und/oder Bor-dotiertes -Zink-Oxid und Antimon-Zinn-Oxid ausgewählt. Das erste und gegebenenfalls das zweite optisch transparente, elektrisch leitfähige Material weisen dabei eine elektrische Leifähigkeit im Bereich von 2·10³ bis 100·10¹ S/m bzw. einen spezifischen Widerstand im Bereich von 1 · 10⁻⁴ bis 50·10⁻⁴ Qcm (Flächenwiderstand < 10 Ω/□) auf.

Vorzugsweise hat die Schicht aus dem ersten optisch transparenten, elektrisch leitfähigen Material und/oder die Schicht aus dem zweiten optisch transparenten, elektrisch leitfähigen Material eine Dicke im Bereich von 10 bis 100 nm, besonders bevorzugt im Bereich von 10 bis 50 nm. Für den Fall, dass die Schicht aus dem zweiten optisch transparenten, elektrisch leitfähigen Material auch zwischen dem mindestens einen Rückseitenkontakt und dem Halbleitermaterial angeordnet ist, kann die Dicke dieser Schicht in den ersten lateralen Bereichen der Rückseite der Solarzeile auch verringert sein und bspw. nur größer oder gleich 10 % der Dicke der Schicht in den zweiten lateralen Bereichen der Rückseite der Solarzeile betragen.

Die Schicht aus dem ersten optisch transparenten, elektrisch leitfähigen Material und die Schicht aus dem zweiten optisch transparenten, elektrisch leitfähigen Material können aus demselben oder aus unterschiedlichen Materialien bestehen und die gleiche oder unterschiedliche Dicken aufweisen.

Das erste und das zweite optisch intransparente, elektrisch leitfähige Material sind vorzugsweise aus der Gruppe bestehend aus Aluminium, Silber, Kupfer, Nickel, Vanadium und Kombinationen und Legierungen der Selbigen ausgewählt, wobei dies dasselbe Material oder unterschiedliche Materialien sein können. Das erste und das zweite optisch intransparente, elektrisch leitfähige Material zeichnen sich durch eine hohe elektrische Leitfähigkeit, eine große Langzeitstabilität und die Eignung zur Verbindung mit anderen Baugruppen, z.B. eines Solarmoduls, aus.

Vorzugsweise weisen die erste und/oder die zweite Oberflächenpassivierungsschicht eine Dicke im Bereich von 1 bis 20 nm auf und bestehen aus einem Material, das aus der Gruppe bestehend aus Siliziumoxid, Siliziumnitrid, Siliziumoxynitrid und Aluminiumoxid ausgewählt ist. Das Material und/oder die Dicke der ersten und der zweiten Oberflächenpassivierungsschicht können gleich oder verschieden voneinander sein.

Der erste Bereich des Halbleitermaterials ist vorzugsweise n-leitend dotiert und ist der Emitter der Solarzelle mit einem elektrischen Flächenwiderstand im Bereich von 100 bis 200 Ω (Ω/□). In diesem Fall ist der zweite Bereich des Halbleitermaterials p-dotiert und bildet die Basis (bulk) der Solarzelle.

In einer anderen Ausführungsform ist der erste Bereich des Halbleitermaterials n-dotiert und bildet die Basis (bulk) der Solarzelle, während der zweite Bereich des Halbleitermaterials p-dotiert ist und den Emitter der Solarzelle bildet und einen elektrischen Flächenwiderstand im Bereich von 120 bis 200 Ω (Ω/□) aufweist. In dieser Ausführungsform ist die Anordnung des zweiten optisch transparenten, elektrisch leitfähigen Materials in den zweiten lateralen Bereichen der Rückseite der Solarzelle oder in den ersten und den zweiten lateralen Bereichen der Rückseite der Solarzelle, wie oben beschrieben, von besonderem Vorteil.

Das erfindungsgemäße Verfahren zur Herstellung einer erfindungsgemäßen kristallinen Solarzelle weist die Schritte zum Bereitstellen eines Halbleitermaterials mit einem ersten Bereich und einem zweiten Bereich, zum Erzeugen einer ersten Oberflächenpassivierungsschicht, durch die Ladungsträger hindurchtreten können, auf oder an einer ersten Oberfläche des Halbleitermaterials, zum Aufbringen eines ersten optisch intransparenten, elektrisch leitfähigen Materials auf der ersten Oberflächenpassivierungsschicht in ersten lateralen Bereichen der ersten Oberfläche des Halbleitermaterials und zum Erzeugen mindestens eines direkten oder indirekten elektrisch leitenden Kontaktes zwischen dem ersten optisch intransparenten, elektrisch leitfähigen Material und dem ersten Bereich des Halbleitermaterials in den ersten lateralen Bereichen der ersten Oberfläche des Halbleitermaterials, zum Aufbringen einer Schicht aus einem ersten optisch transparenten, elektrisch leitfähigem Material auf der ersten Oberflächenpassivierungsschicht in zweiten lateralen Bereichen der ersten Oberfläche des Halbleitermaterials und zum Aufbringen eines zweiten optisch intransparenten, elektrisch leitfähigen Materials in ersten lateralen Bereichen einer zweiten Oberfläche des Halbleitermaterials und zum Erzeugen mindestens eines direkten oder indirekten elektrisch leitenden Kontaktes zwischen dem zweiten optisch intransparenten, elektrisch leitfähigen Material und dem zweiten Bereich des Halbleitermaterials in den ersten lateralen Bereichen der zweiten Oberfläche des Halbleitermaterials auf. Dabei sind der erste Bereich und der zweite Bereich des Halbleitermaterials so dotiert, dass ein pn-Übergang zwischen dem ersten Bereich und dem zweiten Bereich vorliegt. Die erste Oberfläche ist dadurch gekennzeichnet, dass nur der erste Bereich des Halbleitermaterials an sie angrenzt, und stellt die, auf jeden Fall einer Lichtquelle zugewandte Seite der herzustellenden Solarzelle, d.h. die Vorderseite, dar. Die zweite Oberfläche ist dadurch gekennzeichnet, dass nur der zweite Bereich des Halbleitermaterials an sie angrenzt, und stellt die, einer Lichtquelle abgewandte Seite der herzustellenden Solarzelle, d.h. die Rückseite, dar. Damit liegt die zweite Oberfläche des Halbleitermaterials der ersten Oberfläche des Halbleitermaterials gegenüber.

Im Laufe des Verfahrens, vorzugsweise während des Schrittes zum Aufbringen der Schicht aus dem ersten optisch transparenten, elektrisch leitfähigen Material, wird ein elektrisch leitender Kontakt zwischen dieser Schicht und dem ersten optisch intransparenten, elektrisch leitfähigen Material sowie ein elektrisch leitender Kontakt zwischen der Schicht aus dem ersten optisch transparenten, elektrisch leitfähigen Material und dem ersten Bereich des Halbleitermaterials erzeugt.

Der Schritt zum Aufbringen des ersten optisch transparenten, elektrisch leitfähigen Materials wird erfindungsgemäß nach dem Schritt zum Aufbringen des ersten optisch intransparenten, elektrisch leitfähigen Materials, d.h. nach der Abscheidung des Materials des mindestens eines Vorderseitenkontaktes, ausgeführt. Der Schritt zum Aufbringen eines zweiten optisch intransparenten, elektrisch leitfähigen Materials in die ersten lateralen Bereiche einer zweiten Oberfläche des Halbleitermaterials und zum Erzeugen des mindestens eines direkten oder indirekten elektrisch leitenden Kontaktes zwischen dem zweiten optisch intransparenten, elektrisch leitfähigen Material und dem zweiten Bereich des Halbleitermaterials, d.h. die Herstellung mindestens eines Rückseitenkontaktes, kann vor oder nach oder zwischen den Schritten zum Abscheiden und Herstellen des Vorderseitenkontaktes und zum Aufbringen der Schicht aus dem ersten optisch transparenten, elektrisch leitfähigen Material ausgeführt werden. Vorzugsweise wird der zum Aufbringen eines zweiten optisch intransparenten, elektrisch leitfähigen Materials vor oder zwischen den Schritten zum Abscheiden und Herstellen des Vorderseitenkontaktes und zum Aufbringen der Schicht aus dem ersten optisch transparenten, elektrisch leitfähigen Material ausgeführt.

Optional wird nach dem Aufbringen des ersten optisch intransparenten, elektrisch leitfähigen Materials eine Temperaturbehandlung ausgeführt. Die Temperaturbehandlung bewirkt eine Diffusion des ersten optisch intransparenten, elektrisch leitfähigen Materials in oder durch die darunterliegende erste Oberflächenpassivierungsschicht und stellt damit den direkten elektrisch leitenden Kontakt zum ersten Bereich des Halbleitermaterials her oder verbessert den indirekten elektrisch leitenden Kontakt zum ersten Bereich des Halbleitermaterials. Diese Temperaturbehandlung wird jedoch im Gegensatz zum Durchfeuern oder Firing bei niedrigeren Temperaturen von ca. 200 bis 560°C ausgeführt. Die Temperaturbehandlung erfolgt vorzugsweise nach dem Aufbringen der Schicht aus dem ersten optisch transparenten, elektrisch leitfähigen Material und besonders bevorzugt auch nach einem Schritt zum Aufbringen einer Antireflektionsschicht über der Schicht aus dem ersten optisch transparenten, elektrisch leitfähigen Material und kann eine Beleuchtung des gesamten Schichtaufbaus mit normalem (weißem) Licht (z.B. einer Halogenlampe) mit einer Stärke von größer als oder gleich 1000 W/m² für einige Sekunden (≥ 10 s) bis einigen Minuten einschließen. Besonders bevorzugt erfolgt die Temperaturbehandlung erst nach dem Aufbringen aller funktionalen Schichten der Solarzelle, d.h. nach dem Aufbringen des ersten und des zweiten optisch intransparenten, elektrisch leitfähigen Materials, des ersten und ggf. eines zweiten optisch transparenten, elektrisch leitfähigen Materials, ggf. eines elektrisch isolierenden Materials und einer ersten und ggf. einer zweiten Antireflektionsschicht.

In einer Ausführungsform des Verfahrens wird vor oder nach dem Schritt zum Aufbringen des zweiten optisch intransparenten, elektrisch leitfähigen Materials in den ersten lateralen Bereichen der zweiten Oberfläche des Halbleitermaterials eine Schicht aus einem elektrisch isolierenden Material über der zweiten Oberfläche des Halbleitermaterials in zweiten lateralen Bereichen der zweiten Oberfläche des Halbleitermaterials aufgebracht. Damit wird der zweite Bereich des Halbleitermaterials in den zweiten lateralen Bereichen elektrisch isoliert, so dass eine Solarzelle mit passivierter Rückseite erzeugt wird. Die zweiten lateralen Bereiche der zweiten Oberfläche des Halbleitermaterials sind von den ersten lateralen Bereichen der zweiten Oberfläche des Halbleitermaterials verschieden. Wird das elektrisch isolierende Material vor dem Schritt zum Aufbringen des zweiten optisch intransparenten, elektrisch leitfähigen Materials aufgebracht, so kann das elektrisch isolierende Material ganzflächig auf der zweiten Oberfläche des Halbleitermaterials ausgebildet werden. Im Anschluss wird das elektrisch isolierende Material aus den ersten lateralen Bereichen der zweiten Oberfläche des Halbleitermaterials wieder entfernt.

In einer anderen Ausführungsform des Verfahrens wird vor oder nach dem Schritt zum Aufbringen des zweiten optisch intransparenten, elektrisch leitfähigen Materials in den ersten lateralen Bereichen der zweiten Oberfläche des Halbleitermaterials eine Schicht aus einem zweiten optisch transparenten, elektrisch leitfähigen Material in zweiten lateralen Bereichen der zweiten Oberfläche des Halbleitermaterials aufgebracht. Dabei sind die zweiten lateralen Bereiche der zweiten Oberfläche von den ersten lateralen Bereichen der zweiten Oberfläche verschieden. Letztlich wird ein elektrisch leitender Kontakt zwischen der Schicht aus dem zweiten optisch transparenten, elektrisch leitfähigen Material und dem zweiten optisch intransparenten, elektrisch leitfähigen Material sowie zwischen der Schicht aus dem zweiten optisch transparenten, elektrisch leitfähigen Material und dem zweiten Bereich des Halbleitermaterials erzeugt. Bei der Herstellung des Rückseitenkontaktes ist dabei die Ausführungsform, wie sie bezüglich der Herstellung des Vorderseitenkontaktes beschrieben wurde, möglich. Das heißt, zunächst kann das zweite optisch intransparente, elektrisch leitfähige Material in den ersten lateralen Bereichen der zweiten Oberfläche des Halbleitermaterials aufgebracht und danach die Schicht aus dem zweiten optisch transparenten, elektrisch leitfähigen Material in den zweiten lateralen Bereichen der zweiten Oberfläche des Halbleitermaterials aufgebracht werden. Jedoch ist auch eine Ausführungsform, bei der zuerst die Schicht aus dem zweiten optisch transparenten, elektrisch leitfähigen Material ganzflächig über der zweiten Oberfläche des Halbleitermaterials und anschließend das zweite optisch intransparente, elektrisch leitfähige Material in den ersten lateralen Bereichen der zweiten Oberfläche des Halbleitermaterials aufgebracht wird, möglich. Dabei kann der Kontakt des zweiten optisch intransparenten, elektrisch leitfähigen Materials zum zweiten Bereich des Halbleitermaterials erzeugt werden, wie dies mit Bezug auf die Herstellung einer Solarzelle mit passivierter Rückseite beschrieben wurde.

Vorzugsweise wird vor dem Schritt zum Aufbringen des zweiten optisch intransparenten, elektrisch leitfähigen Materials und vor dem Schritt zum Aufbringen der Schicht aus dem zweiten optisch transparenten, elektrisch leitfähigen Material eine zweite Oberflächenpassivierungsschicht, durch die Ladungsträger hindurchtreten können, auf oder an der zweiten Oberfläche des Halbleitermaterials erzeugt.

In einer bevorzugten Ausführungsform wird über der Schicht aus dem ersten optisch transparenten, elektrisch leitfähigen Material eine erste Antireflektionsschicht und/oder gegebenenfalls über der Schicht aus dem zweiten optisch transparenten, elektrisch leitfähigen Material eine zweite Antireflektionsschicht aufgebracht. Zumindest die erste Antireflektionsschicht wird somit nach dem Aufbringen des ersten optisch intransparenten, elektrisch leitfähigen Materials aufgebracht.

Vorzugsweise werden die Schicht aus dem ersten optisch transparenten, elektrisch leitfähigen Material und die erste Antireflektionsschicht und/oder gegebenenfalls die Schicht aus dem zweiten optisch transparenten, elektrisch leitfähigen Material und die zweite Antireflektionsschicht jeweils in einer Anlage und ohne Unterbrechung eines Vakuums aufgebracht. Damit kann eine Feuchtigkeitsaufnahme der Schicht aus dem ersten optisch transparenten, elektrisch leitfähigen Material bzw. der Schicht aus dem zweiten optisch transparenten, elektrisch leitfähigen Material während einer Vakuumunterbrechung vermieden und damit die jeweilige Schicht vor Korrosion geschützt und die Langzeitstabilität ihrer Parameter verbessert werden.

Die Schicht aus dem ersten optisch transparenten, elektrisch leitfähigen Material und/oder die Schicht aus dem zweiten optisch transparenten, elektrisch leitfähigen Material werden vorzugsweise mittels eines PECVD-Prozesses (Plasmaunterstützte chemische Gasphasenabscheidung, Plasma Enhanced Chemical Vapour Deposition), bei dem ein Plasma in einer Plasmazone vorliegt, abgeschieden. Dabei sind Prozesse, die eine geringe Oberflächenschädigung des Halbleitermaterials bewirken, besonders bevorzugt. Solche Prozesse sind beispielsweise Plasmaprozesse, bei denen das Plasma durch Mikrowellen angeregt wird und/oder bei denen die Plasmazone von der jeweiligen zu beschichtenden Oberfläche des Halbleitermaterials räumlich zurückgesetzt ist. Dies ermöglicht eine sehr schonende Abscheidung des optisch transparenten, elektrisch leitfähigen Materials, ohne die jeweilige Oberfläche des Halbleitermaterials durch das Auftreffen von hochenergetischen Ionen zu stören. Darüber hinaus bietet das Abscheiden dieser Schichten mittels PECVD-Prozess den Vorteil, dass das jeweilige optisch transparente, elektrisch leitfähige Material sowie die jeweilige Antireflektionsschicht auf dem jeweiligen optisch intransparenten, elektrisch leitfähigen Material schlecht aufwächst (selektiver Prozess). Damit kann das optisch transparente, elektrisch leitfähige Material, welches den mindestens einen Vorderseitenkontakt oder den mindestens einen Rückseitenkontakt der hergestellten Solarzelle bildet, einfach und ohne kompliziertes Entfernen von überlagerten Schichten direkt von außen elektrisch kontaktiert werden. Vorzugsweise wird die zu beschichtende Oberfläche (101a, 102a) des Halbleitermaterials (10) während des Abscheideprozesses linear an der Plasmazone vorbeibewegt.

Vorzugsweise sind das erste und/oder das zweite optisch transparente, elektrisch leitfähige Material ein Zinkoxid, das besonders bevorzugt mit Aluminium oder Bor dotiert ist. Das bevorzugte Abscheideverfahren für dieses Material ist ein Mikrowellen-gestützter PECVD-Prozess mit den Ausgangsstoffen Diethylzink (DEtZ oder DEZ) oder Dimethylzink (DMZ) als Zinklieferant, Distickstoffmonoxid (N₂O, Lachgas) und/oder Sauerstoff (O₂) als Sauerstofflieferant sowie einem Inertgas (Argon, Neon oder Helium) und/oder Stickstoff. Für die Abscheidung eines Aluminium-dotierten Zinkoxids wird darüber hinaus vorzugsweise Trimethylaluminium (TMAI oder TMA) als Aluminiumquelle und für die Abscheidung eines Bor-dotierten Zinkoxids vorzugsweise Diboran (B₂H₆) als Borquelle hinzugefügt.

Im Nachfolgenden soll die Erfindung anhand von Ausführungsbeispielen und Figuren verdeutlicht werden, wobei gleichartige Elemente, Schichten oder Bereiche mit gleichen Bezugszeichen gekennzeichnet, Größen- und Dickenverhältnisse jedoch nicht maßstabsgerecht dargestellt sind.

Es zeigen:
- Fig. 1: eine erste Ausführungsform der erfindungsgemäßen Solarzelle (1) mit einer passivierten Rückseite;
- Fig. 2: eine zweite Ausführungsform der erfindungsgemäßen Solarzelle (1) mit einer Schicht (19) aus einem zweiten optisch transparenten, elektrisch leitfähigen Material auf der Rückseite, wobei die Schicht (19) aus dem zweiten optisch transparenten, elektrisch leitfähigen Material nur in zweiten lateralen Bereichen (106) der Rückseite angeordnet ist;
- Fig. 3: eine dritte Ausführungsform der erfindungsgemäßen Solarzelle (1) mit einer Schicht (19) aus einem zweiten optisch transparenten, elektrisch leitfähigen Material auf der Rückseite, wobei die Schicht (19) aus dem zweiten optisch transparenten, elektrisch leitfähigen Material auch in ersten lateralen Bereichen (105) der Rückseite angeordnet ist; und
- Fig. 4A bis 4D: eine beispielhafte Ausführungsform des erfindungsgemäßen Verfahrens anhand von Querschnitten durch die Solarzelle in unterschiedlichen Verfahrensstadien.

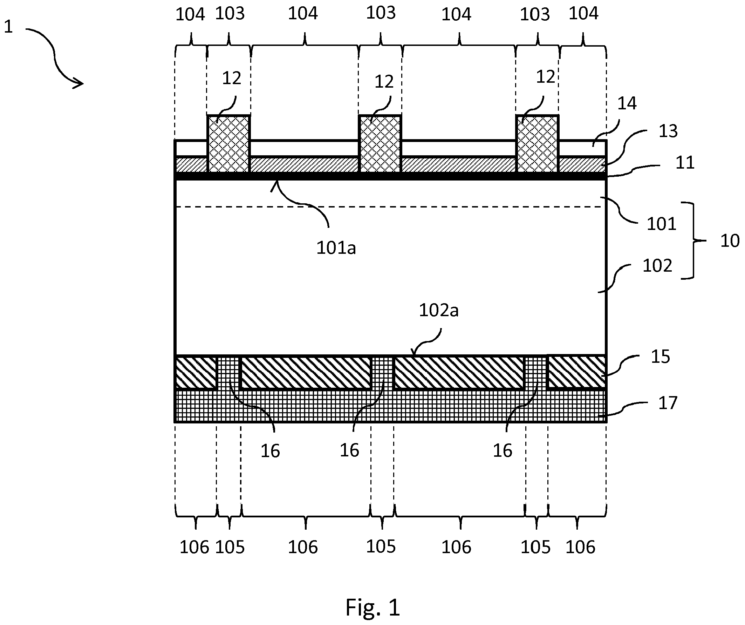

**Figur 1** zeigt eine erste Ausführungsform der erfindungsgemäßen kristallinen Solarzelle (1) in einem Querschnitt. Die Solarzelle (1) weist ein einkristallines Halbleitermaterial (10), bspw. aus Silizium, auf, in dem ein erster Bereich (101) und ein zweiter Bereich (102) ausgebildet sind, die jeweils eine derartige Dotierung aufweisen, dass ein pn-Übergang zwischen dem ersten Bereich (101) und dem zweiten Bereich (102) vorliegt. Im vorliegenden Fall ist der erste Bereich (101) n-dotiert, weist einen Flächenwiderstand im Bereich von 100 bis 200 Ω (Ω/□) auf und dient als Emitter der Solarzelle (1), während der zweite Bereich (102) p-dotiert ist. Das Halbleitermaterial (10) hat eine erste Oberfläche (101a), an die nur der erste Bereich (101) des Halbleitermaterials (10) angrenzt und die die Vorderseite (dem Licht zugewandte Seite) der Solarzelle (1) ist, und eine zweite Oberfläche (102a), an die nur der zweite Bereich (102) des Halbleitermaterials (102) angrenzt und die die Rückseite (die dem Licht abgewandte Seite) der Solarzelle (1) ist. Die erste Oberfläche (101a) liegt der zweiten Oberfläche (102a) gegenüber. Die erste Oberfläche (101a) kann eine Textur, d.h. eine Oberflächenstruktur, gemäß dem Stand der Technik aufweisen, die den Eintritt des Lichtes in das Halbleitermaterial (10) verbessert. Diese Textur ist in der Fig. 1 nicht dargestellt. Der erste Bereich (101) des Halbleitermaterials wurde durch das Einbringen von n-dotierenden Dotanden, bspw. Phosphor (P), Arsen (As) oder Antimon (Sb), in das Halbleitermaterial, bspw. mittels Diffusion oder Ionenimplantation, erzeugt.

Auf oder an der ersten Oberfläche (101a) des Halbleitermaterials (10) ist eine erste Oberflächenpassivierungsschicht (11), bspw. aus SiO₂ oder SiON, angeordnet. Die erste Oberflächenpassivierungsschicht (11) kann auf der ersten Oberfläche (101a) abgeschieden oder durch eine Umwandlung des Halbleitermaterials (10), bspw. durch Oxidation, erzeugt werden. Die Oberflächenpassivierungsschicht (11) bedeckt dabei in der in Fig. 1 dargestellten Ausführungsform die erste Oberfläche (101a) des Halbleitermaterials über die gesamte laterale Ausdehnung der ersten Oberfläche (101a). Die laterale Ausdehnung ist die Ausdehnung in einer Ebene senkrecht zur dargestellten Querschnittsebene.

Auf der Vorderseite der Solarzelle (1) ist mindestens ein Vorderseitenkontakt (12), im dargestellten Fall drei Vorderseitenkontakte (12), aus einem ersten optisch intransparenten, elektrisch leitfähigen Material, bspw. Ag, in ersten lateralen Bereichen (103) der Vorderseite angeordnet. Die erste Oberflächenpassivierungsschicht (11) liegt dabei zwischen dem Vorderseitenkontakt (12) und der ersten Oberfläche (101a) des Halbleitermaterials (10) vor, so dass ein indirekter, elektrisch leitender Kontakt zwischen dem Vorderseitenkontakt (12) und dem ersten Bereich (101) des Halbleitermaterials (10) besteht. Die ersten lateralen Bereiche (103) können eine beliebige Form in einer Draufsicht auf die Vorderseite der Solarzelle (1), d.h. in einer Ebene senkrecht zur dargestellten Querschnittsebene, aufweisen. Insbesondere können die lateralen Bereiche (103) rechteckige, geradlinig verlaufende Streifen oder gewundene Streifen, die sich in die Zeichnungsebene hinein erstrecken, oder kreisförmige, elliptische, drei- oder mehreckige oder frei geformte Flächen sein. Dabei können die ersten lateralen Bereiche (103) regelmäßig oder unregelmäßig über die gesamte Vorderseite der Solarzelle (1) verteilt angeordnet sein. Die Dicke des ersten optisch intransparenten, elektrisch leitenden Materials des Vorderseitenkontakts (12) liegt im Bereich zwischen 5 bis 25 µm.

In zweiten lateralen Bereichen (104) der Vorderseite der Solarzelle (1) ist eine Schicht (13) aus einem ersten optisch transparenten, elektrisch leitfähigen Material, bspw. AlZnO (Aluminiumdotiertes Zinkoxid), über der ersten Oberflächenpassivierungsschicht (11) und der ersten Oberfläche (101a) des Halbleitermaterials (10) angeordnet. Daher liegt ein indirekter, elektrisch leitender Kontakt zwischen der Schicht (13) aus dem ersten optisch transparenten, elektrisch leitfähigen Material und dem ersten Bereich (101) des Halbleitermaterials (10) vor. Die zweiten lateralen Bereiche (104) grenzen an die ersten lateralen Bereiche (103) der Vorderseite der Solarzelle (1) an und bilden gemeinsam mit diesen die gesamte Vorderseite der Solarzelle (1) ab. Damit weisen die zweiten lateralen Bereiche (104) eine Form in der Draufsicht auf die Vorderseite der Solarzelle (1) auf, die zu der Form der ersten lateralen Bereiche (103) komplementär ist. Der Anteil der ersten lateralen Bereiche (103) an der gesamten Fläche der Vorderseite der Solarzelle (1) in der Draufsicht liegt im Bereich von 1,5 bis 3,0 %.

Die Schicht (13) aus dem ersten optisch transparenten, elektrisch leitfähigen Material weist eine Dicke im Bereich von 10 bis 50 nm, vorzugsweise von 30 nm, auf und steht in direktem elektrischen Kontakt mit dem Vorderseitenkontakt (12).

Die erste Oberflächenpassivierungsschicht (11) ist mit einer Dicke von 1 bis 2 nm so dünn, dass Ladungsträger durch sie zwischen dem ersten Bereich (101) des Halbleitermaterials (10) und dem Vorderseitenkontakt (12) bzw. der Schicht (13) aus dem ersten optisch transparenten, elektrisch leitfähigen Material hindurchtreten können.

In den zweiten lateralen Bereichen (104) der Vorderseite der Solarzelle (1) ist des Weiteren eine erste Antireflektionschicht (14) angeordnet, die aus Siliziumnitrid (SiN) besteht und eine Dicke von 50 bis 100 nm aufweist. Diese erste Antireflektionsschicht (14) verringert die Reflexion des auf die Solarzelle (1) auftreffenden Lichtes und verbessert den Eintritt des Lichtes in die Solarzelle (1).

Kennzeichnend für die erfindungsgemäße Solarzelle (1) in dieser und allen anderen Ausführungsformen ist, dass die Schicht (13) aus dem ersten optisch transparenten, elektrisch leitfähigen Material, und vorzugsweise auch die erste Antireflektionsschicht (14), auf der Vorderseite ausschließlich in den zweiten lateralen Bereichen (104) ausgebildet ist und in den ersten lateralen Bereichen (103) nicht vorliegt. Damit ist der elektrische Kontakt des oder der Vorderseitenkontakte (12) zum Halbleitermaterial und die Haftung des oder der Vorderseitenkontakte (12) wesentlich gegenüber einem Aufbau, in dem zwischen dem Vorderseitenkontakt und dem Halbleitermaterial ein Bereich eines elektrisch schlechter leitenden Materials, wie bspw. eines transparenten, elektrisch leitenden Oxids, vorliegt, verbessert.

Auf der Rückseite der Solarzelle (1) ist mindestens ein Rückseitenkontakt (16), im dargestellten Fall drei Rückseitenkontakte (16), aus einem zweiten optisch intransparenten, elektrisch leitfähigen Material, bspw. Al, in ersten lateralen Bereichen (105) der Rückseite angeordnet. Die Rückseitenkontakte (16) grenzen direkt an die zweite Oberfläche (102a) des Halbleitermaterials (10) an, so dass ein direkter, elektrisch leitender Kontakt zwischen dem Rückseitenkontakt (16) und dem zweiten Bereich (102) des Halbleitermaterials (10) vorliegt. Die ersten lateralen Bereiche (105) der Rückseite können, wie bereits mit Bezug auf die ersten lateralen Bereiche (103) der Vorderseite beschrieben, eine beliebige Form in einer Draufsicht auf die Rückseite der Solarzelle (1) aufweisen und beliebig über die gesamte Rückseite verteilt angeordnet sein.

In zweiten lateralen Bereichen (106) der Rückseite der Solarzelle (1) ist eine 5 bis 200 nm dicke dielektrische Schicht (15) an der zweiten Oberfläche (102a) des Halbleitermaterials (10) angeordnet. Die dielektrische Schicht (15) besteht bspw. aus Aluminiumoxid, Siliziumoxid, Siliziumnitrid oder Siliziumoxynitrid, oder anderen für die Passivierung und elektrische Isolierung von p-type Si-Oberflächen geeigneten Materialien oder einer Sequenz aus Schichten aus verschiedenen dieser Materialien. Sie isoliert die zweite Oberfläche (102a) des Halbleitermaterials (10) elektrisch von einer Rückseitenverbindung (17), die die einzelnen, lokalen Rückseitenkontakte (16) miteinander verbindet. Die Rückseitenverbindung (17) kann aus demselben Material wie die Rückseitenkontakte (16) bestehen und mit diesen zusammen aufgebracht werden. Beispielhaft besteht die dielektrische Schicht (15) aus einer 20 nm dünnen Aluminiumoxid-Schicht (AlOx) und einer 140 nm dicken Siliziumnitridschicht. Die Gesamtdicke des zweiten optisch intransparenten, elektrisch leitfähigen Materials des Rückseitenkontakts (16) und der Rückseitenverbindung (17) liegt im Bereich zwischen 3 bis 30 µm, vorzugweise bei 20 µm.

Die zweiten lateralen Bereiche (106) grenzen an die ersten lateralen Bereiche (105) der Rückseite der Solarzelle (1) an und bilden gemeinsam mit diesen die gesamte Rückseite der Solarzelle (1) ab. Damit weisen die zweiten lateralen Bereiche (106) eine Form in der Draufsicht auf die Rückseite der Solarzelle (1) auf, die zu der Form der ersten lateralen Bereiche (105) komplementär ist. Der Anteil der ersten lateralen Bereiche (105) an der gesamten Fläche der Rückseite der Solarzelle (1) in der Draufsicht liegt im Bereich von 1 bis 5 %. Dabei können die Form und/oder die Abmessungen und/oder die laterale Verteilung und/oder der Anteil der ersten lateralen Bereiche (105) der Rückseite der Solarzelle (1) gleich oder verschieden zu der Form und/oder den Abmessungen und/oder der lateralen Verteilung und/oder dem Anteil der ersten lateralen Bereiche (103) der Vorderseite der Solarzelle (1) sein und unabhängig von diesen über die laterale Ausdehnung der Rückseite der Solarzelle (1) verteilt angeordnet sein.

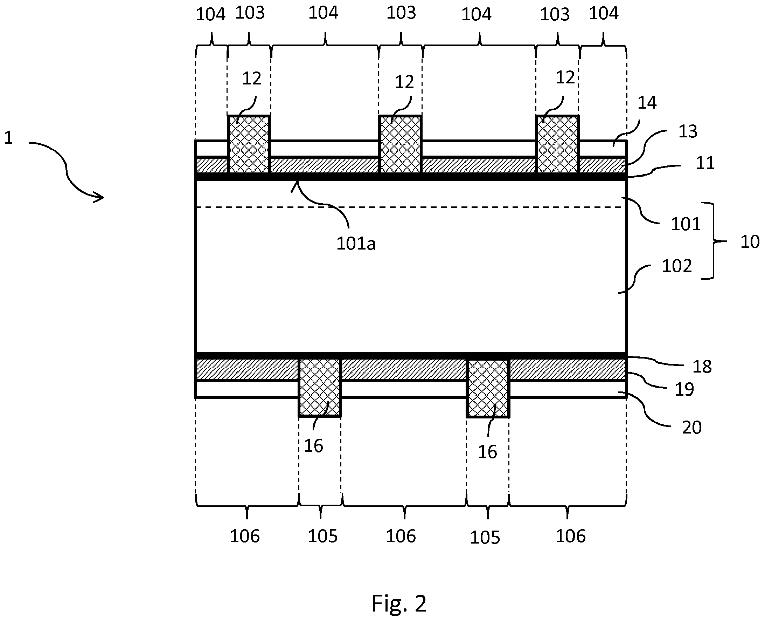

Die in **Figur 2** dargestellte zweite Ausführungsform der erfindungsgemäßen kristallinen Solarzelle (1) unterscheidet sich von der ersten Ausführungsform dadurch, dass die Solarzelle (1) eine bifaziale Solarzelle ist, deren Rückseite nahezu gleichartig wie die Vorderseite ausgebildet ist. Insbesondere weist die Rückseite statt der dielektrischen Schicht eine zweite Oberflächenpassivierungsschicht (18) und eine Schicht (19) aus einem zweiten optisch transparenten, elektrisch leitfähigen Material in den zweiten lateralen Bereichen (106) auf.

Die zweite Oberflächenpassivierungsschicht (18), bspw. aus Aluminium- oder Siliziumoxid, ist auf oder an der zweiten Oberfläche (102a) des Halbleitermaterials (10) angeordnet. Die zweite Oberflächenpassivierungsschicht (18) kann auf der zweiten Oberfläche (102a) abgeschieden oder durch eine Umwandlung des Halbleitermaterials (10), bspw. durch Oxidation, erzeugt werden. Die zweite Oberflächenpassivierungsschicht (18) bedeckt dabei in der in Fig. 2 dargestellten Ausführungsform die zweite Oberfläche (102a) des Halbleitermaterials über die gesamte laterale Ausdehnung der zweiten Oberfläche (102a).

Wie bereits mit Bezug auf Fig. 1 erläutert, ist auf der Rückseite der Solarzelle (1) mindestens ein Rückseitenkontakt (16), im dargestellten Fall zwei Rückseitenkontakte (16), aus einem zweiten optisch intransparenten, elektrisch leitfähigen Material, bspw. Al, in ersten lateralen Bereichen (105) der Rückseite angeordnet. Dabei ist zwischen dem Rückseitenkontakt (16) und der zweiten Oberfläche (102a) des Halbleitermaterials (10) die zweite Oberflächenpassivierungsschicht (18) angeordnet, so dass ein indirekter, elektrisch leitender Kontakt zwischen dem Rückseitenkontakt (16) und dem zweiten Bereich (102) des Halbleitermaterials (10) vorliegt.

In den zweiten lateralen Bereichen (106) der Rückseite der Solarzelle (1) ist die Schicht (19) aus dem zweiten optisch transparenten, elektrisch leitfähigen Material, bspw. ZnO (Stickstoff dotiertes Zinkoxid) oder ITO (Indium-Zinn-Oxid) angeordnet. Die Schicht (19) aus dem zweiten optisch transparenten, elektrisch leitfähigen Material steht in elektrisch leitendem Kontakt mit dem Rückseitenkontakt (16) und über die zweite Oberflächenpassivierungsschicht (18) auch mit dem zweiten Bereich (102) des Halbleitermaterials (10).

Die zweite Oberflächenpassivierungsschicht (18) weist wiederum eine Dicke im Bereich von 1 bis 2 nm auf, so dass Ladungsträger durch sie zwischen dem zweiten Bereich (102) des Halbleitermaterials (10) und der Schicht (19) aus dem zweiten optisch transparenten, elektrisch leitfähigen Material hindurchtreten können. Die Schicht (19) aus dem zweiten optisch transparenten, elektrisch leitfähigen Material ist in den zweiten lateralen Bereichen (106) mit einer Dicke im Bereich von 10 bis 50 nm ausgebildet. Die Dicke des zweiten optisch intransparenten, elektrisch leitfähigen Materials des Rückseitenkontakts (16) liegt im Bereich zwischen 3 bis 30 µm, vorzugweise bei 20 µm.

In den zweiten lateralen Bereichen (106) der Rückseite der Solarzelle (1) ist des Weiteren eine zweite Antireflektionsschicht (20) angeordnet, die aus Siliziumnitrid oder Siliziumoxynitrid besteht und eine Dicke von 50 bis 100 nm aufweist. Das Material und/oder die Dicke der zweiten Antireflektionsschicht (20) kann dabei gleich oder verschieden zu dem Material und/oder der Dicke der ersten Antireflektionsschicht (14) sein. Die zweite Antireflektionsschicht (20) verringert die Reflexion des auf die Rückseite der Solarzelle (1) auftreffenden Lichtes und verbessert den Eintritt des Lichtes von der Rückseite aus in die Solarzelle (1).

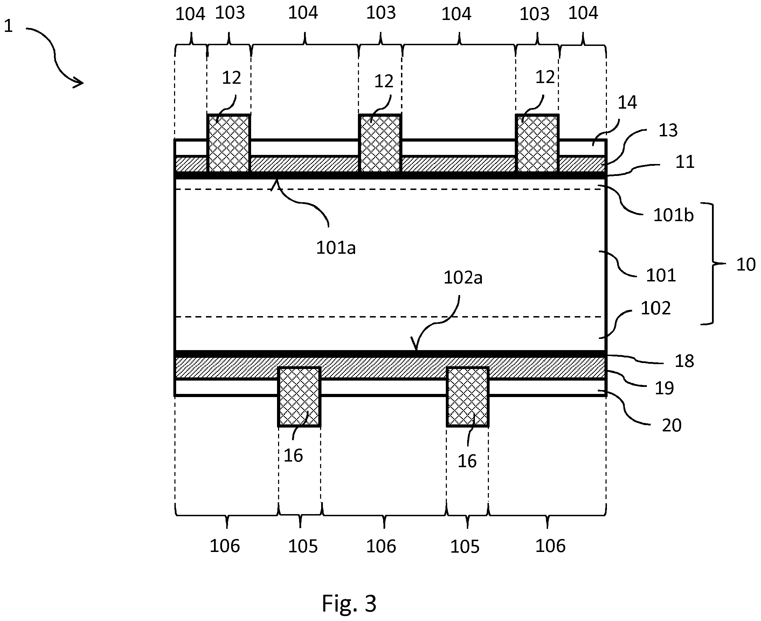

In **Figur 3** ist eine dritte Ausführungsform der erfindungsgemäßen Solarzelle (1) im Querschnitt dargestellt. Hier ist der erste Bereich (101) des Halbleitermaterials (10) n-dotiert und weist angrenzend an die erste Oberfläche (101a) einen Teilbereich (101b) auf, der eine erhöhte Dotierung der gleichen Dotierungsart aufweist als der übrige erste Bereich (101). Der zweite Bereich (102) ist demgegenüber p-dotiert, weist einen Flächenwiderstand im Bereich von 120 bis 200 Ω (Ω/□) auf und dient als Emitter der Solarzelle (n- PERL BJ). Auch hier kann die erste Oberfläche (101a) eine Textur, d.h. eine Oberflächenstruktur, aufweisen, die den Eintritt des Lichtes in das Halbleitermaterial (10) verbessert, wobei diese Textur in der Fig. 3 nicht dargestellt ist. Bei einer Gesamtdicke des Halbleitermaterials (10) von größer oder gleich 10 µm weist der Teilbereich (101b) des ersten Bereiches (101) bspw. eine Dicke von 300 nm und der zweite Bereich (102) eine Dicke von 600 nm auf.

Auf der Vorderseite der Solarzelle (1) sind mindestens ein Vorderseitenkontakt (12) in ersten lateralen Bereichen (103) der Vorderseite der Solarzelle (1), eine Schicht (13) aus einem ersten optisch transparenten, elektrisch leitfähigen Material und eine erste Antireflektionsschicht (14) wie mit Bezug auf Fig. 1 beschrieben angeordnet.

Auf oder an der zweiten Oberfläche (102a) des Halbleitermaterials (10) ist, wie mit Bezug auf Fig. 2 beschrieben, eine zweite Oberflächenpassivierungsschicht (18), mindestens ein Rückseitenkontakt (16), eine Schicht (19) aus einem zweiten optisch transparenten, elektrisch leitfähigen Material und eine zweite Antireflektionsschicht (20) angeordnet, Der einzige Unterschied zwischen den Rückseiten der Solarzelle (1) in der in Fig. 3 dargestellten Ausführungsform und der in Fig. 2 dargestellten Ausführungsform besteht darin, dass die Schicht (19) aus einem zweiten optisch transparenten, elektrisch leitfähigen Material nicht nur in den zweiten lateralen Bereichen (106) der Rückseite der Solarzelle (1), sondern auch in den ersten lateralen Bereichen (105) der Rückseite der Solarzelle (1) vorliegt. Damit sind zwischen dem Rückseitenkontakt (16) und der zweiten Oberfläche (102a) des Halbleitermaterials (10) die zweite Oberflächenpassivierungsschicht (18) und die Schicht (19) aus dem zweiten optisch transparenten, elektrisch leitfähigen Material angeordnet.

Die Schicht (19) aus dem zweiten optisch transparenten, elektrisch leitfähigen Material liegt in dem in Fig. 3 dargestellten Ausführungsbeispiel in den ersten lateralen Bereichen (105) mit einer geringeren Dicke vor als in den zweiten lateralen Bereichen (106), kann jedoch auch dieselbe Dicke aufweisen.

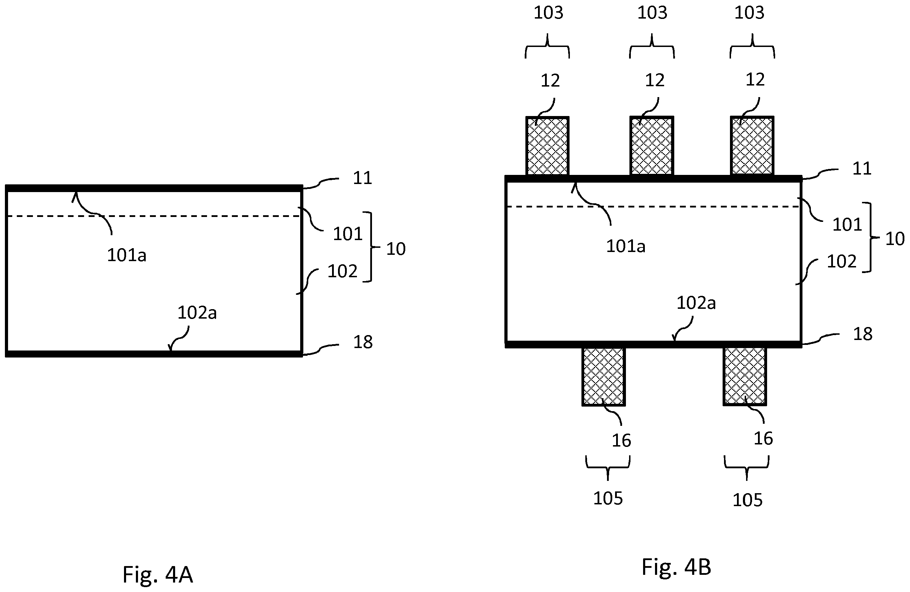

Anhand der **Figuren 4A bis 4D** wird nunmehr eine beispielhafte Ausführungsform des erfindungsgemäßen Verfahrens zur Herstellung einer erfindungsgemäßen Solarzelle beschrieben. Dabei zeigen die Figuren jeweils Querschnitte durch die Solarzelle nach Beendigung verschiedener Verfahrensschritte.

In **Figur 4A** ist ein Halbleitermaterial (10) dargestellt, in dem der erste Bereich (101) und der zweite Bereich (102) vorliegen. Gegebenenfalls ausgebildete Oberflächentexturen sind in den Fig. 4A bis 4F nicht dargestellt. Auf der ersten Oberfläche (101a) des Halbleitermaterials (10) wurde ganzflächig eine erste Oberflächenpassivierungsschicht (11) und auf der zweiten Oberfläche (102a) des Halbleitermaterials (10) ganzflächig eine zweite Oberflächenpassivierungsschicht (18) erzeugt. Diese Schichten bestehen aus Siliziumoxid und weisen eine Dicke von 1 bis 2 nm auf. Sie wurden mittels Rapid Thermal Oxidation, nasschemischer Oxidation oder einer UV- und Ozon unterstützten Trockenoxidation (SQi) erzeugt.

Im nächsten Verfahrensschritt werden auf der ersten Oberfläche (101a) Vorderseitenkontakte (12) aus einem ersten optisch intransparenten, elektrisch leitfähigen Material und auf der zweiten Oberfläche (102a) des Halbleitermaterials (10) Rückseitenkontakte (16) aus einem zweiten optisch intransparenten, elektrisch leitfähigen Material erzeugt. Die Vorder- und Rückseitenkontakte (12, 16) werden mittels Siebdruck (Screenprint) in den ersten lateralen Bereichen (103, 105) der jeweiligen Oberfläche (101a, 102a) aufgebracht und bestehen bspw. aus einer Silberpaste. Das Ergebnis dieses Verfahrensschrittes ist in **Fig. 4B** dargestellt.

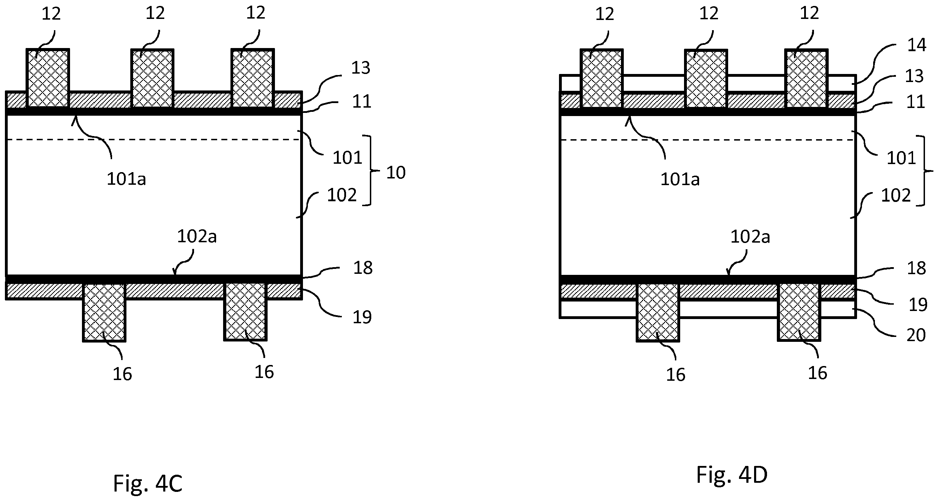

Nachfolgend wird auf den freiliegenden Bereichen der ersten Oberflächenpassivierungsschicht (11), d.h. zwischen den Vorderseitenkontakten (12) aus dem ersten optisch intransparenten, elektrisch leitfähigen Material, eine Schicht (13) aus einem ersten optisch transparenten, elektrisch leitfähigen Material sowie auf den freiliegenden Bereichen der zweiten Oberflächenpassivierungsschicht (18), d.h. zwischen den Rückseitenkontakten (16) aus dem zweiten optisch intransparenten, elektrisch leitfähigen Material, eine Schicht (19) aus einem zweiten optisch transparenten, elektrisch leitfähigen Material aufgebracht aufgebracht, was in **Fig. 4C** gezeigt ist. Das erste optisch transparente, elektrisch leitfähige Material und das zweite optisch transparente, elektrisch leitfähige Material ist Aluminium- oder Bor-dotiertes Zinkoxid, das eine Dicke von jeweils ca. 30 nm aufweist. Die Dotierung entspricht dabei dem Leitungstyp des an die jeweilige Oberflächenpassivierungsschicht (11, 18) angrenzenden Halbleiterbereichs (101, 102).

**Fig. 4D** zeigt die Solarzelle nach einem Verfahrensschritt, in dem eine erste Antireflektionsschicht (14) auf die Schicht (13) aus dem ersten optisch transparenten, elektrisch leitfähigen Material und eine zweite Antireflektionsschicht (20) auf die Schicht (19) aus dem zweiten optisch transparenten, elektrisch leitfähigen Material erzeugt wurden. Die erste Antireflektionsschicht (14) und die zweite Antireflektionsschicht (20) bestehen aus Siliziumnitrid und haben jeweils eine Dicke von ca. 60 nm.

Die Schicht (13) aus dem ersten optisch transparenten, elektrisch leitfähigen Material, die Schicht (19) aus dem zweiten optisch transparenten, elektrisch leitfähigen Material, sowie die erste Antireflektionsschicht (14) und die zweite Antireflektionsschicht (20) wurden in ein und derselben Beschichtungsanlage in der genannten Reihenfolge erzeugt. Jedoch sind auch unterschiedliche Beschichtungsanlagen sowie andere Reihenfolgen der Schichtabscheidungen möglich, solange der gewünschte Aufbau der Solarzelle realisiert wird.

In einem abschließenden Schritt wird der Aufbau aus Fig. 4D einer Temperaturbehandlung unterzogen. Dabei wird die Solarzelle für ca. 1 min (eine Minute) einer Temperatur von 200°C bis 300°C ausgesetzt. Zusätzlich kann eine Beleuchtung mit weißem Licht mit einer Stärke von mindestens 1000 W/m² vorgenommen werden, wodurch die Parameter der Solarzelle verbessert werden können. Der Aufbau der Solarzelle wird durch den Temperaturschritt jedoch nicht strukturell verändert. Lediglich das erste und/oder das zweite optisch intransparente, elektrisch leitfähige Material kann in oder durch die jeweilige erste bzw. zweite Oberflächenpassivierungsschicht (11 bzw. 18) diffundieren. Im Ergebnis erhält man eine Solarzelle, wie sie in Fig. 2 dargestellt ist, wobei kein Durchfeuern der Kontakte notwendig ist. In **Tabelle 1** werden beispielhafte Prozessparameter für eine PECVD-Abscheidung der Schicht aus dem ersten und/oder zweiten optisch transparenten, elektrisch leitfähigen Material aus Aluminium- oder Bor-dotiertem Zinkoxid angegeben. Diese beziehen sich auf eine PECVD-Anlage mit einem Remote-Mikrowellen-Plasma, bei dem der Plasmaraum räumlich von der zu beschichtenden Oberfläche eines Substrates zurückgesetzt, d.h. beabstandet, ist. Damit wird die Schädigung der zu beschichtenden Oberfläche durch lonenbombardement aus dem Plasma reduziert.

| Parameter | Bereich | Bevorzugter Wert |
|---|---|---|
| Prozessdruck (Kammerdruck) | 0,1 - 0,2 mbar (10 - 20 Pa) | 0,15 mbar (15 Pa) |
| Prozesstemperatur (Substrattemperatur) | 100 - 400 °C | 250°C |
| Mikrowellen-Plasma-Leistung | 300 - 1000 W | 600 W |
| Mikrowellen-Spitze | 2000 - 3000 W | 2500 W |
| Pulsdauer und Frequenz der MW-Leistung | T = 16 - 32ms; f = 31 - 62 Hz (t_{ON} = 4-6 ms, toFF = 12-26 ms) | T = 22 ms; f = 45 Hz (t_{ON} = 5 ms, toFF = 17 ms) |
| Gasflussverhältnis N₂O/DEZ | 10-20 | 15 |
| Gasflussverhältnis O₂/DEZ | 7-15 | 10 |
| Gasfluss DEZ* | 100 sccm = 550 mgm | |
| Gasfluss N₂O* | 1500 sccm | |
| Gasfluss O₂* | 1000 sccm | |
| Gasfluss Ar* | 400 sccm | |
| Gasfluss TMAI | 10 mgm | vorgemischt mit 2% in DEZ |
| Gasfluss B₂H₆ | 200 sccm | 1% in H₂ |
| Dotierstoffkonzentration | 1 - 5 % | 2% |

| | | |
|---|---|---|
| Tabelle 1; * pro Plasmaquelle | | |

Einige oder alle der genannten Ausführungsformen der Solarzelle oder des Verfahrens zur Herstellung einer Solarzelle können auch miteinander kombiniert werden, solange sie sich nicht gegenseitig ausschließen.

### Bezugszeichen

- 1: Solarzelle
- 10: Halbleitermaterial
- 101: Erster Bereich des Halbleitermaterials
- 101a: Erste Oberfläche des Halbleitermaterials
- 101b: Teilbereich des ersten Bereiches
- 102: Zweiter Bereich des Halbleitermaterials
- 102a: Zweite Oberfläche des Halbleitermaterials
- 103: Erster lateraler Bereich der Vorderseite
- 104: Zweiter lateraler Bereich der Vorderseite
- 105: Erster lateraler Bereich der Rückseite
- 106: Zweiter lateraler Bereich der Rückseite
- 11: Erste Oberflächenpassivierungsschicht
- 12: Vorderseitenkontakt
- 13: Schicht aus erstem optisch transparenten, elektrisch leitfähigen Material
- 14: Erste Antireflektionsschicht
- 15: Dielektrische Schicht
- 151: Erste Teilschicht
- 152: Zweite Teilschicht
- 16: Rückseitenkontakt
- 17: Rückseitenverbindung
- 18: Zweite Oberflächenpassivierungsschicht
- 19: Schicht aus zweitem optisch transparenten, elektrisch leitfähigen Material
- 20: Zweite Antireflektionsschicht

## Patentansprüche

1. Kristalline Solarzelle (1) mit einem ersten Bereich (101) eines Halbleitermaterials (10) mit einer ersten Dotierung, einem zweiten Bereich (102) des Halbleitermaterials (10) mit einer zweiten Dotierung, so dass ein pn-Übergang zwischen dem ersten und dem zweiten Bereich (101, 102) vorliegt, mindestens einem Vorderseitenkontakt (12) aus einem ersten optisch intransparenten, elektrisch leitfähigen Material, der den ersten Bereich (101) des Halbleitermaterials (10) direkt oder indirekt in ersten lateralen Bereichen (103) der Vorderseite der Solarzelle elektrisch leitend kontaktiert, und mindestens einem lokalen Rückseitenkontakt (16) aus einem zweiten optisch intransparenten, elektrisch leitfähigen Material, der den zweiten Bereich (102) des Halbleitermaterials (10) direkt oder indirekt in ersten lateralen Bereichen (105) der Rückseite der Solarzelle elektrisch leitend kontaktiert, **dadurch gekennzeichnet, dass** auf der Vorderseite der Solarzelle ausschließlich in zweiten lateralen Bereichen (104) eine Schicht (13) aus einem ersten optisch transparenten, elektrisch leitfähigen Material über dem ersten Bereich (101) des Halbleitermaterials (10) angeordnet und mit dem mindestens einen Vorderseitenkontakt (14) elektrisch leitend verbunden ist, wobei zwischen der Schicht (13) aus dem ersten optisch transparenten, elektrisch leitfähigen Material und dem ersten Bereich (101) des Halbleitermaterials (10) eine erste Oberflächenpassivierungsschicht (11) angeordnet ist, durch die Ladungsträger hindurchtreten können, so dass die Schicht (13) aus dem ersten optisch transparenten, elektrisch leitfähigen Material in indirektem, elektrisch leitendem Kontakt mit dem ersten Bereich (101) des Halbleitermaterials (10) steht, und wobei die zweiten lateralen Bereiche (104) der Vorderseite der Solarzelle von den ersten lateralen Bereichen (103) der Vorderseite der Solarzelle verschieden sind.

2. Kristalline Solarzelle nach Anspruch 1, **dadurch gekennzeichnet, dass** die erste Oberflächenpassivierungsschicht (11) auch zwischen dem Vorderseitenkontakt (12) und dem ersten Bereich (101) des Halbleitermaterials (10) angeordnet ist.

3. Kristalline Solarzelle nach Anspruch 1 oder 2, **dadurch gekennzeichnet, dass** in zweiten lateralen Bereichen (106) der Rückseite der Solarzelle eine Schicht (15) aus einem elektrisch isolierenden Material über dem zweiten Bereich (102) des Halbleitermaterials (10) angeordnet ist, so dass der zweite Bereich (102) des Halbleitermaterials (10) in den zweiten lateralen Bereichen (106) elektrisch isoliert ist, wobei die zweiten lateralen Bereiche (106) der Rückseite der Solarzelle von den ersten lateralen Bereichen (105) der Rückseite der Solarzelle verschieden sind.

4. Kristalline Solarzelle nach Anspruch 1 oder 2, **dadurch gekennzeichnet, dass** in zweiten lateralen Bereichen (106) der Rückseite der Solarzelle eine Schicht (19) aus einem zweiten optisch transparenten, elektrisch leitfähigen Material über dem zweiten Bereich (102) des Halbleitermaterials (10) angeordnet und mit dem mindestens einen Rückseitenkontakt (16) elektrisch leitend verbunden ist, wobei die Schicht (19) aus dem zweiten optisch transparenten, elektrisch leitfähigen Material in direktem oder indirektem, elektrisch leitendem Kontakt mit dem zweiten Bereich (102) des Halbleitermaterials (10) steht und wobei die zweiten lateralen Bereiche (106) der Rückseite der Solarzelle von den ersten lateralen Bereichen (105) der Rückseite der Solarzelle verschieden sind.

5. Kristalline Solarzelle nach Anspruch 4, **dadurch gekennzeichnet, dass** das zweite optisch transparente, elektrisch leitfähige Material auch zwischen dem zweiten Bereich (102) des Halbleitermaterials (10) und dem Rückseitenkontakt (16) angeordnet ist.

6. Kristalline Solarzelle nach Anspruch 4 oder 5, **dadurch gekennzeichnet, dass** zwischen der Schicht (19) aus dem zweiten optisch transparenten, elektrisch leitfähigen Material und dem zweiten Bereich (102) des Halbleitermaterials (10) und/oder zwischen dem Rückseitenkontakt (16) und dem zweiten Bereich (102) des Halbleitermaterials (10) eine zweite Oberflächenpassivierungsschicht (18) angeordnet ist, durch die Ladungsträger hindurchtreten können.

7. Kristalline Solarzelle nach einem der vorhergehenden Ansprüche, **dadurch gekennzeichnet, dass** das erste und/oder das zweite optisch transparente, elektrisch leitfähige Material aus der Gruppe bestehend aus Indium-Zinn-Oxid, Fluor-Zinn-Oxid, Antimon-Zinn-Oxid, Aluminium-Zink-Oxid und Bor-Zink-Oxid ausgewählt sind.

8. Kristalline Solarzelle nach einem der vorhergehenden Ansprüche, **dadurch gekennzeichnet, dass** die Schicht (13) aus dem ersten optisch transparenten, elektrisch leitfähigen Material und/oder die Schicht (19) aus dem zweiten optisch transparenten, elektrisch leitfähigen Material eine Dicke im Bereich von 10 bis 100 nm aufweisen.

9. Kristalline Solarzelle nach einem der vorhergehenden Ansprüche, **dadurch gekennzeichnet, dass** das erste und das zweite optisch intransparente, elektrisch leitfähige Material aus der Gruppe bestehend aus Aluminium, Silber, Kupfer, Nickel, Vanadium und Kombinationen und Legierungen der Selbigen ausgewählt sind.

10. Kristalline Solarzelle nach einem der vorhergehenden Ansprüche, **dadurch gekennzeichnet, dass** die erste und/oder die zweite Oberflächenpassivierungsschicht (11, 18) eine Dicke im Bereich von 1 bis 20 nm aufweisen und aus einem Material, das aus der Gruppe bestehend aus Siliziumoxid, Siliziumnitrid, Siliziumoxynitrid und Aluminiumoxid ausgewählt ist, bestehen.

11. Verfahren zur Herstellung einer kristallinen Solarzelle (1) nach einem der Ansprüche 1 bis 10 mit den Schritten:
- Bereitstellen eines Halbleitermaterials (10) mit einem ersten Bereich (101) und einem zweiten Bereich (102), wobei der erste Bereich (101) und der zweite Bereich (102) so dotiert sind, dass ein pn-Übergang zwischen dem ersten Bereich (101) und dem zweiten Bereich (102) vorliegt,
- Erzeugen einer ersten Oberflächenpassivierungsschicht (11), durch die Ladungsträger hindurchtreten können, auf oder an einer ersten Oberfläche (101a) des Halbleitermaterials (10), wobei nur der erste Bereich (101) des Halbleitermaterials (10) an die erste Oberfläche (101a) angrenzt,
- Aufbringen eines ersten optisch intransparenten, elektrisch leitfähigen Materials auf der ersten Oberflächenpassivierungsschicht (11) in ersten lateralen Bereichen (103) der ersten Oberfläche (101a) des Halbleitermaterials (10) und Erzeugen mindestens eines direkten oder indirekten elektrisch leitenden Kontaktes (12) zwischen dem ersten optisch intransparenten, elektrisch leitfähigen Material und dem ersten Bereich (101) des Halbleitermaterials (10) in den ersten lateralen Bereichen (103) der ersten Oberfläche (101a) des Halbleitermaterials (10),
- Aufbringen einer Schicht (13) aus einem ersten optisch transparenten, elektrisch leitfähigen Material auf der ersten Oberflächenpassivierungsschicht (11) in zweiten lateralen Bereichen (104) der ersten Oberfläche des Halbleitermaterials (10) nach dem Aufbringen des ersten optisch intransparenten, elektrisch leitfähigen Materials, wobei ein elektrisch leitender Kontakt zwischen der Schicht (13) aus dem ersten optisch transparenten, elektrisch leitfähigen Material und dem ersten optisch intransparenten, elektrisch leitfähigen Material sowie ein elektrisch leitender Kontakt zwischen der Schicht (13) aus dem ersten optisch transparenten, elektrisch leitfähigen Material und dem ersten Bereich (101) des Halbleitermaterials (10) erzeugt wird, wobei die zweiten lateralen Bereiche (104) verschieden von den ersten lateralen Bereichen (103) sind, und
- Aufbringen eines zweiten optisch intransparenten, elektrisch leitfähigen Materials in ersten lateralen Bereichen (105) einer zweiten Oberfläche (102a) des Halbleitermaterials (10) und Erzeugen mindestens eines direkten oder indirekten elektrisch leitenden Kontaktes (16) zwischen dem zweiten optisch intransparenten, elektrisch leitfähigen Material und dem zweiten Bereich (102) des Halbleitermaterials (10) in den ersten lateralen Bereichen (105) der zweiten Oberfläche (102a) des Halbleitermaterials (10), wobei nur der zweite Bereich (102) des Halbleitermaterials (10) an die zweite Oberfläche (102a) angrenzt und die zweite Oberfläche (102a) des Halbleitermaterials (10) der ersten Oberfläche (101a) des Halbleitermaterials (10) gegenüberliegt.

12. Verfahren nach Anspruch 11, **dadurch gekennzeichnet, dass** vor oder nach dem Schritt zum Aufbringen des zweiten optisch intransparenten, elektrisch leitfähigen Materials in den ersten lateralen Bereichen (105) der zweiten Oberfläche (102a) des Halbleitermaterials (10) eine Schicht (15) aus einem elektrisch isolierenden Material über der zweiten Oberfläche (102a) des Halbleitermaterials (10) in zweiten lateralen Bereichen (106) der zweiten Oberfläche des Halbleitermaterials (10) aufgebracht wird, so dass der zweite Bereich (102) des Halbleitermaterials (10) in den zweiten lateralen Bereichen (106) elektrisch isoliert ist, wobei die zweiten lateralen Bereiche (106) der zweiten Oberfläche (102a) des Halbleitermaterials (10) von den ersten lateralen Bereichen (105) der zweiten Oberfläche (102a) des Halbleitermaterials (10) verschieden sind.

13. Verfahren nach Anspruch 11, **dadurch gekennzeichnet, dass** vor oder nach dem Schritt zum Aufbringen des zweiten optisch intransparenten, elektrisch leitfähigen Materials in den ersten lateralen Bereichen (105) der zweiten Oberfläche (102a) des Halbleitermaterials (10) eine Schicht (19) aus einem zweiten optisch transparenten, elektrisch leitfähigen Material über der zweiten Oberfläche (102a) des Halbleitermaterials (10) in zweiten lateralen Bereichen (106) der zweiten Oberfläche des Halbleitermaterials (10) aufgebracht wird, wobei ein elektrisch leitender Kontakt zwischen der Schicht (19) aus dem zweiten optisch transparenten, elektrisch leitfähigen Material und dem zweiten optisch intransparenten, elektrisch leitfähigen Material sowie ein elektrisch leitender Kontakt zwischen der Schicht (19) aus dem zweiten optisch transparenten, elektrisch leitfähigen und dem zweiten Bereich (102) des Halbleitermaterials (10) erzeugt wird, wobei die zweiten lateralen Bereiche (106) der zweiten Oberfläche (102a) verschieden von den ersten lateralen Bereichen (105) der zweiten Oberfläche (102a) sind.

14. Verfahren nach Anspruch 13, **dadurch gekennzeichnet, dass** vor dem Schritt zum Aufbringen des zweiten optisch intransparenten, elektrisch leitfähigen Materials in ersten lateralen Bereichen (105) einer zweiten Oberfläche (102a) des Halbleitermaterials (10) und vor dem Schritt zum Aufbringen der Schicht (19) aus dem zweiten optisch transparenten, elektrisch leitfähigen Material eine zweite Oberflächenpassivierungsschicht (18), durch die Ladungsträger hindurchtreten können, auf oder an der zweiten Oberfläche (102a) des Halbleitermaterials (10) erzeugt wird.

15. Verfahren nach einem der Ansprüche 11 bis 14, **dadurch gekennzeichnet, dass** über der Schicht (13) aus dem ersten optisch transparenten, elektrisch leitenden Material eine erste Antireflektionsschicht (14) und/oder über der Schicht (19) aus dem zweiten optisch transparenten, elektrisch leitfähigen Material eine zweite Antireflektionsschicht (20) aufgebracht wird.

16. Verfahren nach Anspruch 15, **dadurch gekennzeichnet, dass** die Schicht (13) aus dem ersten optisch transparenten, elektrisch leitenden Material und de erste Antireflektionsschicht (14) und/oder die Schicht (19) aus dem zweiten optisch transparenten, elektrisch leitfähigen Material und die zweite Antireflektionsschicht (20) in einer Anlage und ohne Unterbrechung eines Vakuums aufgebracht werden.

17. Verfahren nach einem der Ansprüche 11 bis 16, **dadurch gekennzeichnet, dass** die Schicht (13) aus dem ersten optisch transparenten, elektrisch leitfähigen Material und/oder die Schicht (19) aus dem zweiten optisch transparenten, elektrisch leitfähigen Material mittels eines PECVD-Prozesses, bei dem ein Plasma in einer Plasmazone vorliegt, abgeschieden wird.

18. Verfahren nach Anspruch 17, **dadurch gekennzeichnet, dass** während des PECVD-Prozesses Energie in das Plasma durch Mikrowellen eingebracht wird.

19. Verfahren nach Anspruch 17 oder 18, **dadurch gekennzeichnet, dass** die Schicht (13) aus dem ersten optisch transparenten, elektrisch leitfähigen Material und/oder die Schicht (19) aus dem zweiten optisch transparenten, elektrisch leitfähigen Material mit einem PECVD-Prozess abgeschieden wird, bei dem die Plasmazone von der jeweiligen zu beschichtenden Oberfläche (101a, 102a) des Halbleitermaterials (10) räumlich zurückgesetzt ist.

20. Verfahren nach Anspruch 17 oder 18, **dadurch gekennzeichnet, dass** die zu beschichtende Oberfläche (101a, 102a) des Halbleitermaterials (10) linear an der Plasmazone vorbeibewegt wird.

21. Verfahren nach einem der Ansprüche 18 bis 20, **dadurch gekennzeichnet, dass** das erste und/oder das zweite optisch transparente, elektrisch leitfähige Material ein Zinkoxid ist und der PECVD-Prozess mit den Ausgangsstoffen Dimethylzink oder Diethylzink als Zinklieferant, Distickstoffmonoxid und/oder Sauerstoff als Sauerstofflieferant und einem Inertgas und/oder Stickstoff ausgeführt wird.

22. Verfahren nach Anspruch 21, **dadurch gekennzeichnet, dass** weiterhin Trimethylaluminium als Aluminiumquelle zum Aufbringen eines Aluminium-dotierten Zinkoxides oder Diboran als Borquelle zum Aufbringen eins Bor-dotierten Zinkoxides während des PECVD-Prozesses verwendet wird.

## Claims

1. Crystalline solar cell (1) comprising a first region (101) of a semiconductor material (10) having a first doping, a second region (102) of the semiconductor material (10) having a second doping, in such a way that there is a pn junction between the first and the second region (101, 102), at least one front face contact (12) made of a first optically opaque, electrically conductive material, which directly or indirectly electrically conductively contacts the first region (101) of the semiconductor material (10) in first lateral regions (103) of the front face of the solar cell, and at least one local rear face contact (16) made of a second optically opaque, electrically conductive material, which directly or indirectly electrically conductively contacts the second region (102) of the semiconductor material (10) in first lateral regions (105) of the rear face of the solar cell,
**characterised in that** a layer (13) made of a first optically transparent, electrically conductive material is arranged over the first region (101) of the semiconductor material (10) on the front face of the solar cell exclusively in second lateral regions (104), and is electrically conductively connected to the at least one front face contact (14), a first surface passivation layer (11), through which charge carriers can pass, being arranged between the layer (13) made of the first optically transparent, electrically conductive material and the first region (101) of the semiconductor material (10), in such a way that the layer (13) made of the first optically transparent, electrically conductive material is in indirect, electrically conductive contact with the first region (101) of the semiconductor material (10), and the second lateral regions (104) of the front face of the solar cell being different from the first lateral regions (103) of the front face of the solar cell.

2. Crystalline solar cell according to claim 1, **characterised in that** the first surface passivation layer (11) is also arranged between the front face contact (12) and the first region (101) of the semiconductor material (10).

3. Crystalline solar cell according to either claim 1 or claim 2, **characterised in that** a layer (15) made of an electrically insulating material is arranged over the second region (102) of the semiconductor material (10) in second lateral regions (106) of the rear face of the solar cell, in such a way that the second region (102) of the semiconductor material (10) is electrically insulated in the second lateral regions (106), the second lateral regions (106) of the rear face of the solar cell being different from the first lateral regions (105) of the rear face of the solar cell.

4. Crystalline solar cell according to either claim 1 or claim 2, **characterised in that** a layer (19) made of a second optically transparent, electrically conductive material is arranged over the second region (102) of the semiconductor material (10) in second lateral regions (106) of the rear face of the solar cell and is electrically conductively connected to the at least one rear face contact (16), the layer (19) made of the second optically transparent, electrically conductive material being in direct or indirect electrically conductive contact with the second region (102) of the semiconductor material (10) and the second lateral regions (106) of the rear face of the solar cell being different from the first lateral regions (105) of the rear face of the solar cell.

5. Crystalline solar cell according to claim 4, **characterised in that** the second optically transparent, electrically conductive material is also arranged between the second region (102) of the semiconductor material (10) and the rear face contact (16).

6. Crystalline solar cell according to either claim 4 or claim 5, **characterised in that** a second surface passivation layer (18), through which charge carriers can pass, is arranged between the layer (19) made of the second optically transparent, electrically conductive material and the second region (102) of the semiconductor material (10) and/or between the rear face contact (16) and the second region (102) of the semiconductor material (10).

7. Crystalline solar cell according to any of the preceding claims, **characterised in that** the first and/or the second optically transparent, electrically conductive materials are selected from the group consisting of indium-doped tin oxide, fluorine-doped tin oxide, antimony-doped tin oxide, aluminium-doped zinc oxide and boron-doped zinc oxide.

8. Crystalline solar cell according to any of the preceding claims, **characterised in that** the layer (13) made of the first optically transparent, electrically conductive material and/or the layer (19) made of the second optically transparent, electrically conductive material have a thickness in the range of 10 to 100 nm.

9. Crystalline solar cell according to any of the preceding claims, **characterised in that** the first and second optically opaque, electrically conductive materials are selected from the group consisting of aluminium, silver, copper, nickel, vanadium and combinations and alloys thereof.

10. Crystalline solar cell according to any of the preceding claims, **characterised in that** the first and/or second surface passivation layers (11, 18) have a thickness in the range of 1 to 20 nm and consist of a material selected from the group consisting of silicon oxide, silicon nitride, silicon oxynitride and aluminium oxide.

11. Method for manufacturing a crystalline solar cell (1) according to any of claims 1 to 10, comprising the steps of:
- providing a semiconductor material (10) having a first region (101) and a second region (102), the first region (101) and the second region (102) being doped in such a way that there is a pn junction between the first region (101) and the second region (102),
- producing a first surface passivation layer (11), through which charge carriers can pass, on or at a first surface (101a) of the semiconductor material (10), only the first region (101) of the semiconductor material (10) bordering on the first surface (101a),
- applying a first optically opaque, electrically conductive material to the first surface passivation layer (11) in first lateral regions (103) of the first surface (101a) of the semiconductor material (10) and producing at least one direct or indirect electrically conductive contact (12) between the first optically opaque, electrically conductive material and the first region (101) of the semiconductor material (10) in the first lateral regions (103) of the first surface (101a) of the semiconductor material (10),
- applying a layer (13) of a first optically transparent, electrically conductive material to the first surface passivation layer (11) in second lateral regions (104) of the first surface of the semiconductor material (10) after the first optically opaque, electrically conductive material has been applied, electrically conductive contact between the layer (13) made of the first optically transparent, electrically conductive material and the first optically opaque, electrically conductive material and also electrically conductive contact between the layer (13) made of the first optically transparent, electrically conductive material and the first region (101) of the semiconductor material (10) being produced, the second lateral regions (104) being different from the first lateral regions (103), and
- applying a second optically opaque, electrically conductive material in first lateral regions (105) of a second surface (102a) of the semiconductor material (10), and producing at least one direct or indirect electrically conductive contact (16) between the second optically opaque, electrically conductive material and the second region (102) of the semiconductor material (10) in the first lateral regions (105) of the second surface (102a) of the semiconductor material (10), only the second region (102) of the semiconductor material (10) bordering on the second surface (102a), and the second surface (102a) of the semiconductor material (10) being opposite the first surface (101a) of the semiconductor material (10).

12. Method according to claim 11, **characterised in that**, before or after the step of applying the second optically opaque, electrically conductive material in the first lateral regions (105) of the second surface (102a) of the semiconductor material (10), a layer (15) made of an electrically insulating material is applied over the second surface (102a) of the semiconductor material (10) in second lateral regions (106) of the second surface of the semiconductor material (10), in such a way that the second region (102) of the semiconductor material (10) is electrically insulated in the second lateral regions (106), the second lateral regions (106) of the second surface (102a) of the semiconductor material (10) being different from the first lateral regions (105) of the second surface (102a) of the semiconductor material (10).

13. Method according to claim 11, **characterised in that**, before or after the step of applying the second optically opaque, electrically conductive material in the first lateral regions (105) of the second surface (102a) of the semiconductor material (10), a layer (19) made of a second optically transparent, electrically conductive material is applied over the second surface (102a) of the semiconductor material (10) in second lateral regions (106) of the second surface of the semiconductor material (10), an electrically conductive contact being produced between the layer (19) made of the second optically transparent, electrically conductive material and the second optically opaque, electrically conductive material, and an electrically conductive contact being produced between the layer (19) made of the second optically transparent, electrically conductive material and the second region (102) of the semiconductor material (10), the second lateral regions (106) of the second surface (102a) being different from the first lateral regions (105) of the second surface (102a).

14. Method according to claim 13, **characterised in that**, before the step of applying the second optically opaque, electrically conductive material in first lateral regions (105) of a second surface (102a) of the semiconductor material (10) and before the step of applying the layer (19) made of the second optically transparent, electrically conductive material, a second surface passivation layer (18) through which charge carriers can pass is produced at or on the second surface (102a) of the semiconductor material (10).

15. Method according to any of claims 11 to 14, **characterised in that** a first antireflection layer (14) is applied over the layer (13) made of the first optically transparent, electrically conductive material and/or a second antireflection layer (20) is applied over the layer (19) made of the second optically transparent, electrically conductive material.

16. Method according to claim 15, **characterised in that** the layer (13) made of the first optically transparent, electrically conductive material and the first antireflection layer (14) and/or the layer (19) made of the second optically transparent, electrically conductive material and the second antireflection layer (20) are applied in one system without interrupting a vacuum.

17. Method according to any of claims 11 to 16, **characterised in that** the layer (13) made of the first optically transparent, electrically conductive material and/or the layer (19) made of the second optically transparent, electrically conductive material are deposited by a PECVD process, in which a plasma is present in a plasma zone.

18. Method according to claim 17, **characterised in that** energy is introduced into the plasma by microwaves during the PECVD process.

19. Method according to either claim 17 or claim 18, **characterised in that** the layer (13) made of the first optically transparent, electrically conductive material and/or the layer (19) made of the second optically transparent, electrically conductive material are deposited by a PECVD process, in which the plasma zone is spatially set back from the relevant surface (101a, 102a) to be coated of the semiconductor material (10).

20. Method according to either claim 17 or claim 18, **characterised in that** the surface (101a, 102a) to be coated of the semiconductor material (10) is moved past the plasma zone linearly.

21. Method according to any of claims 18 to 20, **characterised in that** the first and/or second optically transparent, electrically conductive materials are a zinc oxide, and the PECVD process is carried out using the starting substances of dimethyl zinc or diethyl zinc as a zinc supplier, dinitrogen monoxide and/or oxygen as an oxygen supplier, and an inert gas and/or nitrogen.

22. Method according to claim 21, **characterised in that** trimethylaluminium is used as an aluminium source for applying an aluminium-doped zinc oxide or diborane is used as a boron source for applying a boron-doped zinc oxide during the PECVD process.

## Revendications

1. Cellule solaire cristalline (1) comportant une première zone (101) d'un matériau semi-conducteur (10) comprenant un premier dopage, une seconde zone (102) du matériau semi-conducteur (10) comprenant un second dopage, de sorte qu'une jonction pn entre les première et seconde zones (101, 102) est présente, au moins un contact côté avant (12) constitué d'un premier matériau optiquement non transparent et électriquement conducteur qui est mis en contact de façon électriquement conductrice avec la première zone (101) du matériau semi-conducteur (10) directement ou indirectement dans des premières zones latérales (103) du côté avant de la cellule solaire, et au moins un contact côté arrière (16) local constitué d'un second matériau optiquement non transparent et électriquement conducteur qui est mis en contact de façon électriquement conductrice avec la seconde zone (102) du matériau semi-conducteur (10) directement ou indirectement dans des premières zones latérales (105) du côté arrière de la cellule solaire, **caractérisée en ce que** sur le côté avant de la cellule solaire, seulement dans des secondes zones latérales (104), une couche (13) constituée d'un premier matériau optiquement transparent et électriquement conducteur est disposée au-dessus de la première zone (101) du matériau semi-conducteur (10) et est reliée de façon électriquement conductrice à l'au moins un contact côté avant (14), une première couche de passivation de surface (11) étant disposée entre la couche (13) constituée du premier matériau optiquement transparent et électriquement conducteur et la première zone (101) du matériau semi-conducteur (10), des porteurs de charge pouvant passer à travers ladite couche de passivation de surface, de sorte que la couche (13) constituée du premier matériau optiquement transparent et électriquement conducteur est en contact électriquement conducteur indirect avec la première zone (101) du matériau semi-conducteur (10), et les secondes zones latérales (104) du côté avant de la cellule solaire étant différentes des premières zones latérales (103) du côté avant de la cellule solaire.

2. Cellule solaire cristalline selon la revendication 1, **caractérisée en ce que** la première couche de passivation de surface (11) est également disposée entre le contact côté avant (12) et la première zone (101) du matériau semi-conducteur (10).

3. Cellule solaire cristalline selon la revendication 1 ou 2, **caractérisée en ce qu'**une couche (15) constituée d'un matériau électriquement isolant est disposée au-dessus de la seconde zone (102) du matériau semi-conducteur (10) dans les secondes zones latérales (106) du côté arrière de la cellule solaire, de sorte que la seconde zone (102) du matériau semi-conducteur (10) est isolée électriquement dans les secondes zones latérales (106), les secondes zones latérales (106) du côté arrière de la cellule solaire étant différentes des premières zones latérales (105) du côté arrière de la cellule solaire.

4. Cellule solaire cristalline selon la revendication 1 ou 2, **caractérisée en ce qu'**une couche (19) constituée d'un second matériau optiquement transparent et électriquement conducteur est disposée au-dessus de la seconde zone (102) du matériau semi-conducteur (10) dans des secondes zones latérales (106) du côté arrière de la cellule solaire et qu'elle est reliée de façon électriquement conductrice à l'au moins un contact côté arrière (16), la couche (19) constituée du second matériau optiquement transparent et électriquement conducteur étant en contact électriquement conducteur direct ou indirect avec la seconde zone (102) du matériau semi-conducteur (10) et les secondes zones latérales (106) du côté arrière de la cellule solaire étant différentes des premières zones latérales (105) du côté arrière de la cellule solaire.

5. Cellule solaire cristalline selon la revendication 4, **caractérisée en ce que** le second matériau optiquement transparent et électriquement conducteur est également disposé entre la seconde zone (102) du matériau semi-conducteur (10) et le contact côté arrière (16).

6. Cellule solaire cristalline selon la revendication 4 ou 5, **caractérisée en ce qu'**une seconde couche de passivation de surface (18) est disposée entre la couche (19) constituée du second matériau optiquement transparent et électriquement conducteur et la seconde zone (102) du matériau semi-conducteur (10) et/ou entre le contact côté arrière (16) et la seconde zone (102) du matériau semi-conducteur (10), des porteurs de charge pouvant passer à travers ladite seconde couche de passivation de surface.

7. Cellule solaire cristalline selon l'une des revendications précédentes, **caractérisée en ce que** le premier et/ou le second matériau optiquement transparent et électriquement conducteur sont sélectionnés dans le groupe constitué par l'oxyde d'étain-indium, l'oxyde d'étain-fluor, l'oxyde d'étain-antimoine, l'oxyde de zinc-aluminium et l'oxyde de zinc-bore.

8. Cellule solaire cristalline selon l'une des revendications précédentes, **caractérisée en ce que** la couche (13) constituée du premier matériau optiquement transparent et électriquement conducteur et/ou la couche (19) constituée du second matériau optiquement transparent et électriquement conducteur présentent une épaisseur dans la plage comprise entre 10 et 100 nm.

9. Cellule solaire cristalline selon l'une des revendications précédentes, **caractérisée en ce que** le premier et le second matériau optiquement non transparent et électriquement conducteur sont sélectionnés dans le groupe constitué par l'aluminium, l'argent, le cuivre, le nickel, le vanadium et les combinaisons et alliages de ceux-ci.

10. Cellule solaire cristalline selon l'une des revendications précédentes, **caractérisée en ce que** la première et/ou la seconde couche de passivation de surface (11, 18) présentent une épaisseur dans la plage comprise entre 1 et 20 nm et sont constituées d'un matériau sélectionné dans le groupe constitué par l'oxyde de silicium, le nitrure de silicium, l'oxynitrure de silicium et l'oxyde d'aluminium.

11. Procédé de fabrication d'une cellule solaire cristalline (1) selon l'une des revendications 1 à 10, comportant les étapes suivantes :
- fourniture d'un matériau semi-conducteur (10) comportant une première zone (101) et une seconde zone (102), la première zone (101) et la seconde zone (102) étant dopées de telle sorte qu'une jonction pn entre la première zone (101) et la seconde zone (102) est présente,
- production d'une première couche de passivation de surface (11) à travers laquelle les porteurs de charge peuvent passer sur ou contre une première surface (101a) du matériau semi-conducteur (10), seule la première zone (101) du matériau semi-conducteur (10) jouxtant la première surface (101a),
- application d'un premier matériau optiquement non transparent et électriquement conducteur sur la première couche de passivation de surface (11) dans des premières zones latérales (103) de la première surface (101a) du matériau semi-conducteur (10) et production d'au moins un contact électriquement conducteur direct ou indirect (12) entre le premier matériau optiquement non transparent et électriquement conducteur et la première zone (101) du matériau semi-conducteur (10) dans les premières zones latérales (103) de la première surface (101a) du matériau semi-conducteur (10),
- application d'une couche (13) d'un premier matériau optiquement transparent et électriquement conducteur sur la première couche de passivation de surface (11) dans des secondes zones latérales (104) de la première surface du matériau semi-conducteur (10) après l'application du premier matériau optiquement non transparent et électriquement conducteur, un contact électriquement conducteur entre la couche (13) constituée du premier matériau optiquement transparent et électriquement conducteur et le premier matériau optiquement non transparent et électriquement conducteur ainsi qu'un contact électriquement conducteur entre la couche (13) constituée du premier matériau optiquement transparent et électriquement conducteur et la première zone (101) du matériau semi-conducteur (10) étant produits, les secondes zones latérales (104) étant différentes des premières régions latérales (103), et
- application d'un second matériau optiquement non transparent et électriquement conducteur dans des premières zones latérales (105) d'une seconde surface (102a) du matériau semi-conducteur (10) et production d'au moins un contact électriquement conducteur direct ou indirect (16) entre le second matériau optiquement non transparent et électriquement conducteur et la seconde zone (102) du matériau semi-conducteur (10) dans les premières zones latérales (105) de la seconde surface (102a) du matériau semi-conducteur (10), seule la seconde zone (102) du matériau semi-conducteur (10) jouxtant la seconde surface (102a) et la seconde surface (102a) du matériau semi-conducteur (10) étant opposée à la première surface (101a) du matériau semi-conducteur (10).

12. Procédé selon la revendication 11, **caractérisé en ce que**, avant ou après l'étape d'application du second matériau optiquement non transparent et électriquement conducteur dans les premières zones latérales (105) de la seconde surface (102a) du matériau semi-conducteur (10), une couche (15) constituée d'un matériau électriquement isolant est appliquée au-dessus de la seconde surface (102a) du matériau semi-conducteur (10) dans les secondes zones latérales (106) de la seconde surface du matériau semi-conducteur (10), de sorte que la seconde zone (102) du matériau semi-conducteur (10) est isolée électriquement dans les secondes zones latérales (106), les secondes zones latérales (106) de la seconde surface (102a) du matériau semi-conducteur (10) étant différentes des premières zones latérales (105) de la seconde surface (102a) du matériau semi-conducteur (10).

13. Procédé selon la revendication 11, **caractérisé en ce que**, avant ou après l'étape d'application du second matériau optiquement non transparent et électriquement conducteur dans les premières zones latérales (105) de la seconde surface (102a) du matériau semi-conducteur (10), une couche (19) constituée d'un second matériau optiquement transparent et électriquement conducteur est appliquée au-dessus de la seconde surface (102a) du matériau semi-conducteur (10) dans des secondes zones latérales (106) de la seconde surface du matériau semi-conducteur (10), un contact électriquement conducteur entre la couche (19) constituée du second matériau optiquement transparent et électriquement conducteur et le second matériau optiquement non transparent et électriquement conducteur ainsi qu'un contact électriquement conducteur entre la couche (19) constituée du second matériau optiquement transparent et électriquement conducteur et la seconde zone (102) du matériau semi-conducteur (10) étant produits, les secondes zones latérales (106) de la seconde surface (102a) étant différentes des premières zones latérales (105) de la seconde surface (102a).

14. Procédé selon la revendication 13, **caractérisé en ce qu'**avant l'étape d'application du second matériau optiquement non transparent et électriquement conducteur dans des premières zones latérales (105) d'une seconde surface (102a) du matériau semi-conducteur (10) et avant l'étape d'application de la couche (19) constituée du second matériau optiquement transparent et électriquement conducteur, une seconde couche de passivation de surface (18), à travers laquelle des porteurs de charge peuvent passer, est produite sur ou contre la seconde surface (102a) du matériau semi-conducteur (10).

15. Procédé selon l'une des revendications 11 à 14, **caractérisé en ce qu'**une première couche antireflet (14) est appliquée au-dessus de la couche (13) constituée du premier matériau optiquement transparent et électriquement conducteur, et/ou **en ce qu'**une seconde couche antireflet (20) est appliquée sur la couche (19) constituée du second matériau optiquement transparent et électriquement conducteur.

16. Procédé selon la revendication 15, **caractérisé en ce que** la couche (13) constituée du premier matériau optiquement transparent et électriquement conducteur et la première couche antireflet (14) et/ou la couche (19) constituée du second matériau optiquement transparent et électriquement conducteur et la seconde couche antireflet (20) sont appliquées dans un système et sans interrompre un vide.

17. Procédé selon l'une des revendications 11 à 16, **caractérisé en ce que** la couche (13) constituée du premier matériau optiquement transparent et électriquement conducteur et/ou la couche (19) constituée du second matériau optiquement transparent et électriquement conducteur sont déchargées au moyen d'un processus PECVD, dans lequel un plasma est présent dans une zone de plasma.

18. Procédé selon la revendication 17, **caractérisé en ce que**, pendant le processus PECVD, de l'énergie est introduite dans le plasma par micro-ondes.

19. Procédé selon la revendication 17 ou 18, **caractérisé en ce que** la couche (13) constituée du premier matériau optiquement transparent et électriquement conducteur et/ou la couche (19) constituée du second matériau optiquement transparent et électriquement conducteur est déchargée par un processus PECVD, dans lequel la zone de plasma est spatialement en retrait par rapport à la surface (101a, 102a) à revêtir respective du matériau semi-conducteur (10).

20. Procédé selon la revendication 17 ou 18, **caractérisé en ce que** la surface (101a, 102a) à revêtir du matériau semi-conducteur (10) est déplacée de façon linéaire le long de la zone de plasma.

21. Procédé selon l'une des revendications 18 à 20, **caractérisé en ce que** le premier et/ou le second matériau optiquement transparent et électriquement conducteur sont un oxyde de zinc et **en ce que** le processus PECVD est effectué au moyen des matières de départ de diméthylzinc ou diéthylzinc comme fournisseur de zinc, monoxyde de diazote et/ou oxygène comme fournisseur d'oxygène et un gaz inerte et/ou de l'azote.

22. Procédé selon la revendication 21, **caractérisé en ce que** le triméthylaluminium est en outre utilisé comme source d'aluminium pour appliquer un oxyde de zinc dopé à l'aluminium ou **en ce que** du diborane est en outre utilisé comme source de bore pour appliquer un oxyde de zinc dopé au bore pendant le processus PECVD.
